# EUROPEAN PATENT SPECIFICATION

(11) **EP 0 875 733 B1**
(45) Date of publication and mention of the grant of the patent: **03.03.2004**
(21) Application number: 98302577.6
(22) Date of filing: 01.04.1998
(51) Int. Cl.: G01D 3/02, G01D 5/244

(54) **Detection of passing magnetic articles using a peak-on-peak percentage threshold detector**
Detektion von sich vorbeibewegenden magnetischen Gegenständen mit einem Schwellwertdetektor, wobei der Schwellwert ein prozentualer Anteil der Spitzenwerte ist
Détection d'articles magnétiques mouvants avec un détecteur à seuil, où le seuil représente un pourcentage de la valeur crête à crête

(30) Priority: 28.04.1997 US 847683
(43) Date of publication of application: 04.11.1998
(73) Proprietor: ALLEGRO MICROSYSTEMS INC., Worcester, Massachusetts 01615 (US)
(72) Inventor: Towne, Jay M., Newbury, New Hampshire 03255 (US); Scheller, Karl P., Rochester, New Hampshire 03867 (US); Vig, Ravi, Bow, New Hampshire 03304 (US)
(74) Representative: Crawford, Andrew Birkby

(56) References cited:
- DE-A- 19 600 803
- US-A- 4 180 704
- US-A- 5 612 618

## Description

### BACKGROUND

This invention relates to a proximity detector, and especially to a ferrous-gear-tooth Hall-transducer, or other magnetic-field-to-voltage transducer, capable of detecting the leading and trailing gear tooth edges of an adjacent rotating ferrous gear, or other magnetic articles, and more particularly relates to such a Hall proximity detector with an automatic gain adjust feature in the Hall-voltage amplifier.

The term "magnetic article" as used herein applies to magnetized bodies, ferrous bodies and other bodies having a low magnetic reluctance that tend to alter the ambient magnetic field.

In the patent U.S. 5,442,283, issued August 15, 1995 there is described a Hall-voltage slope-activated proximity-detector capable of detecting the rising and falling edges of an adjacent rotating gear tooth. This proximity-detector type detector includes an integrated circuit Hall detector mounted to a pole of a magnet, and includes a circuit for tracking a slope of a Hall voltage (e.g. corresponding to the approach of a passing gear tooth) and briefly holding the ensuing peak voltage before producing an output signal indicating the onset of the following Hall-voltage slope of opposite direction (e.g. corresponding to the approach of a valley between two gear teeth). The Hall voltage holding circuit includes a capacitor and circuit means for controllably leaking charge out of or into the capacitor for preventing false tripping of a comparator that provides the pulse output signal.

The holding voltage of the capacitor thus has a droop which leads to increasing loss of holding accuracy as the speed of gear tooth passage becomes slower, and therefore the detector has a minimum gear teeth speed at which accurate detection is possible.

Most proximity detectors of the prior art produce a high binary output voltage indicating approach and proximity of a passing article, and produce a low binary voltage when the article recedes from the detector. The transition in detector output voltage from low to high typically is triggered by a comparator that determines when the transducer voltage rises to a fixed internal threshold voltage reference. Alternatively, in the case of the above described slope-activated detector, the detector determines when a transducer voltage peak has just occurred and the transducer signal voltage drops a predetermined incremental voltage from the peak value.

Prior art proximity detectors having fixed threshold voltages, produce low to high (or high to low) binary transitions in the output signal indicating approach of a magnetic article. In practice, the closest passing distance (sometimes referred to as the air gap) does not remain constant.

Variations of the air gap dimension causes shifts in the actual distances of article approach and receding at which the transducer voltages exceeds or falls below the fixed thresholds. This results in a lack of accuracy of passing detection that may rule out their use as position detectors of passing articles such as cams and gear teeth.

Changes in the air gap, between passing articles to be detected and the transducer, may be attributable to mechanical and electrical properties of the detector as well as in the properties of the passing articles, especially as a function of temperature.

The result is a detection inaccuracy that may rule out the use of such detectors for such critical applications as in combustion-engine ignition distributors. Prominent causes of this inaccuracy stem from the fact that the amplitude of the Hall voltage changes when gear teeth (articles) have different ferro-magnetic properties from tooth to tooth, and/or when undulating changes in the spacings (air gap) of gear teeth to detector are caused by eccentricity of the gear. Also, changes in temperature cause changes in air gap dimensions and in the sensitivity of the transducer and transducer-voltage amplifier.

Whether detection is accomplished by sensing the Hall voltage peaks or using a voltage threshold criteria for indicating approach of a passing article, changes in the median amplitude of the transducer voltage degrade the accuracy of position detection.

Over multiple installations, the effective air gap to which a transducer in the proximity detector may be subject can vary by several millimeters. At a relatively wide air gap, the amplitude of the peak to peak signal generated by the transducer such as the Hall device is many times less than the amplitude of the same signal at a relatively close or narrow air gap. To provide an electrical signal having a substantially constant peak to peak signal amplitude over a majority of the air gap range, the proximity detectors employ automatic gain control (AGC).

With AGC, the gain can be optimised for each air gap to which the proximity detector may be subject after power up. At relatively narrow air gaps, the AGC minimizes the gain to ensure that a magnetic signal having a relatively large amplitude will not result in clipping or other distortion of the electrical signal generated by the transducer. At relatively wide air gaps, the AGC maximises the gain to thus allow processing of electrical signals generated from a magnetic signal having a relatively small amplitude. Thus, by using AGC, the proximity detector can operate over a relatively wide range of air gaps. Moreover, by providing an electrical signal having a substantially constant peak-to-peak signal amplitude regardless of air gap width, the proximity detector provides improved timing accuracy over the entire range of air gap widths.

DE-A-19 600 803 discloses a sensor for detecting rotation of a gear, in which magnetoresistive elements are disposed facing the gear. The signal output from the MRE sensor is an alternating amplitude signal. An operational amplifier has a differential gain exceeding its operational limit relative to the amplitude value of the sensor signal, and it amplifies and outputs the difference between the sensor signal and a reference voltage. Comparators judge whether an output of the operational amplifier is within a predetermined amplitude range relative to the amplitude centre thereof. When the op-amp output deviates from the predetermined amplitude range, transistors either charge or discharge a capacitor, so that the reference voltage can be changed closer to the output of the operational amplifier. Another comparator compares the output signal of the operational amplifier with a threshold value to output a binary-valued signal.

US-A-5 612 618 discloses a detector in which a Hall element detects magnetic signals of a rotational member which is secured to the crank shaft or the cam shaft of an engine and converts them to an alternating electric signal. The electric signal is amplified by a differential amplifier and applied to a peak-detecting-type wave-shaping circuit which generates a rotational position signal and a control signal. A reset signal generator generates an interrupting signal in response to the control signal and is applied to a NAND circuit which is connected between the wave shaping circuit and an output circuit. When a power switch is closed, the power source voltage sometimes drops to an extremely low value for providing the rotational position detecting signal. At this moment, the reset signal generator generates the interrupting signal and closes the NAND circuit so that an erroneous signal of the rotational position detecting signal is prevented.

### SUMMARY OF THE INVENTION

Although peak detectors can detect down to zero speeds, to more accurately detect speeds down to zero, the peak-to-peak percentage threshold detector was conceived. The peak-to-peak percentage threshold detector is sometimes referred to herein as a "threshold detector"or "a zero-crossing mode detector." One problem with peak-to-peak percentage threshold detectors, however, is that it is relatively difficult to start the proximity detector in peak-to-peak percentage threshold detector mode due to erratic and inaccurate switching of the detector output signal caused by the peak-to-peak percentage threshold detector not having the eventual peak and valley values acquired at startup. If the proximity detector includes AGC, whenever AGC is activated, a similar situation arises. Thus, while using AGC improves timing accuracy over air gap, adjusting the gain at any time in a peak-to-peak percentage threshold detector is relatively difficult. For this reason, zero-speed Hall effect gear tooth proximity detectors having AGC do not initially start in peak-to-peak percentage threshold mode, but rather start in a peak detector mode of operation. Furthermore, in previous detectors, the AGC function is activated only while the proximity detector is in peak-detector mode.

In proximity detectors which initially start in peak detector modes immediately after initial power up, the proximity detector has a pair of digital-to-analog converters (DACs) which respectively captures positive and negative peaks of a transducer signal, and switch on some threshold voltage referenced from each peak. Detectors operating in this mode, will hereinafter sometimes be referred to simply as "a peak-referenced detector", "a peak detector" or "a slope-activated detector". After some number of initial cycles, e.g. sixteen cycles, the proximity detector changes from peak-detector mode to peak-to-peak percentage threshold-detector mode.

The initial peak detector mode allows AGC to occur, which could not heretofore be done one increment at a time in proximity detectors operating in the peak-to-peak percentage threshold detector mode without possible false transitions. Also, the initial startup time period is necessary to be certain that peaks which have been captured represent accurately the actual peaks of the magnetic signal in that particular magnetic circuit. It is advantageous to switch from peak detector mode to peak-to-peak percentage threshold mode because in peak-to-peak percentage threshold mode, the switch points are relative to the peak to peak value of the signal which provides improved timing accuracy over variations in air gap.

It would, therefore, be desirable to provide a proximity detector which can initially start in peak-to-peak percentage threshold mode. It would also be desirable to provide a proximity detector which can utilize AGC in peak-to-peak percentage threshold mode. It would be further desirable to provide a circuit which can startup in peak-to-peak percentage threshold detector mode with AGC active.

In accordance with the present invention, a proximity detector for sensing magnetic articles includes a magnetic-field-to-voltage transducer for generating at an output port thereof a signal voltage, V_{sig}, that is proportional to a magnetic field, a peak-to-peak percentage threshold detector having an input port coupled to the output port of said magnetic-field-to-voltage transducer to receive the signal voltage V_{sig} and for providing an output signal voltage Vₒᵤₜ and a forcing circuit coupled to said peak-to-peak percentage threshold detector for forcing and maintaining the value of the output signal voltage Vₒᵤₜ at a first predetermined value during an initial startup interval of the proximity detector. With this particular arrangement a proximity detector which initially starts in a peak-to-peak percentage threshold detector mode of operation is provided. Since there is no transition from peak mode to peak-to-peak percentage of threshold mode as in prior art proximity detectors, there is no abrupt change in timing accuracy.

The peak-to-peak percentage threshold detector includes a first tracking circuit which generates at an output port thereof a signal voltage PDAC that tracks the highest peak of the signal voltage V_{sig} and a second tracking circuit which generates at an output port thereof a signal voltage NDAC that tracks the lowest peak of the signal voltage V_{sig}. Since the proximity detector initially starts in peak-to-peak percentage threshold mode, the signal PDAC provided by the first tracking circuit is initially set to a reset value which is lower than the least positive expected value of the signal voltage V_{sig} and the signal NDAC provided by the second tracking circuit is set to a reset value which is greater than the least negative expected value of the signal voltage V_{sig}. With this technique, the first and second tracking circuits are ensured to capture, respectively, the positive and negative peaks of the signal V_{sig} even with a large negative or positive offset voltage. In one particular embodiment, the proximity detector utilizes a regulated supply voltage of 3.0 volts (V) and the reset value for the PDAC signal provided by the first tracking circuit is 0.57V, and while the reset value for the NDAC signal provided by the second tracking circuit is 2.43V.

With the reset values of PDAC and NDAC as above, during the initial proximity detector startup, the value of NDAC is more positive than the value of PDAC. This relationship of PDAC to NDAC (i.e. PDAC less than NDAC) is not a condition in which the peak-to-peak percentage threshold detector can properly operate. As the first and second tracking circuits acquire the positive and negative peaks, respectively, the values of PDAC and NDAC will cross each other, and at one instant, the value of PDAC will equal the value of NDAC. Consequently, threshold voltages derived from the values of PDAC and NDAC will also be equal. At this point, the output signal Vₒᵤₜ of the peak-to-peak threshold detector would normally switch. In the present invention, however, the forcing circuit coupled to the peak-to-peak percentage threshold detector forces and maintains the value of the output signal voltage Vₒᵤₜ at a first predetermined value during an initial startup interval of the proximity detector. The forcing circuit may be provided for example, from one or more transistor switches, a logic circuit or a current source which biases or otherwise forces the output signal voltage Vₒᵤₜ to a first predetermined voltage level until V_{sig} has changed value by a predetermined amount or until a predetermined period of time passes.

In accordance with a further aspect of the present invention, a proximity detector for sensing magnetic articles includes a magnetic-field-to-voltage transducer for generating at an output port thereof a signal that is proportional to a magnetic field and an automatic gain control circuit for adjusting the amplitude of a signal voltage V_{sig}, the automatic gain control circuit having an input port coupled to the output port of said magnetic-field-to-voltage transducer and having an output port, automatic gain control circuit for controlling the amplitude of a signal voltage V_{sig}. The proximity detector further includes a peak-to-peak percentage threshold detector coupled to the automatic gain control circuit and a forcing circuit coupled to the automatic gain control circuit and the peak-to-peak percentage threshold detector. The peak-peak percentage threshold detector receives the signal voltage V_{sig} and provides an output signal voltage Vₒᵤₜ. The forcing circuit maintains the value of the output signal voltage Vₒᵤₜ at a first predetermined value to prevent the peak-to-peak percentage threshold detector from switching prior to one of a positive or negative excursion of the signal voltage V_{sig} reaching a predetermined voltage when the automatic gain control circuit adjusts the amplitude of the signal voltage V_{sig}. With this particular arrangement, a proximity detector which can operate in peak-to-peak percentage threshold detector mode with automatic gain control (AGC) is provided.

The threshold detector operates as described above, however, when the AGC function is activated, the peak to peak value of the signal V_{sig} changes almost instantaneously due to the change in gain caused by the AGC. When this happens, the first and second tracking circuits in the peak-to-peak percentage threshold detector do not hold the correct values of the respective peaks, and the signal could decrease because of AGC to the point where it will no longer cross the thresholds of the peak-to-peak percentage threshold detector. This would cause the proximity detector output signal Vₒᵤₜ to simply stop switching. Even if the proximity detector output signal Vₒᵤₜ does not stop switching, the timing accuracy will suffer since the thresholds will no longer be in the correct location relative to the actual peak to peak electrical signal. This is because the thresholds are generated from the outputs of the first and second tracking circuits which, under these conditions, would no longer represent the actual positive and negative peaks of the magnetic signal. To overcome these problems, the two tracking circuits are reset when the AGC is activated, such that the signal PDAC provided by the first tracking circuit is set to a value which is lower than the least positive expected value of the signal voltage V_{sig} and the signal NDAC provided by the second tracking circuit is set to a value which is greater than the least negative expected value of the signal voltage V_{sig}. Thus, in this reset state, the value of PDAC is less than the value of NDAC. Since during normal operating conditions of the proximity detector, the value of PDAC is greater than the value of NDAC, the reset values of PDAC and NDAC would cause the output signal voltage Vₒᵤₜ to switch incorrectly. Accordingly, when the first and second tracking circuits are reset, the signal Vₒᵤₜ must be reinforced in its present binary state so that it will not switch due to the values of PDAC and NDAC being set to their reset values. The first and second tracking circuits are then allowed to reacquire the new peaks of the positive and negative going excursions of the signal V_{sig}. The output signal Vₒᵤₜ is maintained in the present binary state until the value of PDAC exceeds the value of NDAC by a predetermined voltage while the PDAC and NDAC values reacquire the respective positive and negative peak values of the signal V_{sig}. It should be noted that the values of PDAC and NDAC reacquire the appropriate values of V_{sig} relatively quickly and thus the reset condition has minimal impact on the performance of the proximity detector.

The reinforcement of the proximity detector's present binary state is accomplished with the use of a forcing circuit which forces and maintains the output voltage Vₒᵤₜ in a predetermined one of its binary states. In one particular embodiment, the forcing circuit is provided from a pair of switches coupled to an input of a threshold comparator of the peak-to-peak percentage threshold detector. The switches are synchronized to the comparator's output. One or the other of the switches is activated to force a reference input to the comparator to one of first and second voltage levels, depending on the present polarity of the output of the threshold comparator. A separate comparator is used to release the forcing circuit after the value of PDAC is a predetermined voltage greater than the value of NDAC. The release comparator is necessary because the proximity detector is incapable of switching while the forcing circuit maintains the output signal at the predetermined voltage. Thus, the release comparator allows the threshold comparator to return to normal operation once the values of PDAC and NDAC take on values within a predetermined range of values relative to one another.

In accordance with a still further aspect of the present invention, a proximity detector of passing magnetic articles includes a magnetic-field-to-voltage transducer for sensing an ambient magnetic field and generating a voltage, V_{H}, having an amplitude that is directly related to the magnetic field. A digitally gain-controlled amplifier is connected to the transducer for amplifying V_{H}. A DC voltage source is provided for generating a target-voltage V_{TG}, and a comparator means has inputs connected to the output of the amplifier and to a DC reference voltage for generating a binary signal V_{toobig} that changes from one to another binary level each time that V_{sig} exceeds V_{TG}.

A circuit means is connected to the output of the amplifier for sensing and counting the excursions of the one polarity in V_{sig}, and for producing a binary count output signal. The output of the circuit means is connected to the amplifier and the circuit means is additionally for at each of the counted excursions in V_{sig}, incrementally changing the transducer gain in the direction to bring the peaks in V_{sig} to just below the target value T_{TG}. This proximity detector also includes a circuit means connected to the output of the amplifier for generating a proximity-detector output voltage, Vₒᵤₜ, having transitions of one polarity each time excursions of the one polarity in V_{sig} reach a predetermined point therein.

In accordance with a yet still further aspect of the present invention, a proximity-detection method for detection of passing magnetic articles begins by sensing an ambient magnetic field and generating a voltage, V_{H}, having an amplitude that is directly related to the magnetic field. The voltage V_{H} is amplified in a digitally-gain-controlled amplifier to generate an amplified signal V_{sig}. The following steps include comparing the amplitudes of the excursions of at least one polarity in V_{sig} to a predetermined target value, generating a digital signal that changes from one to another binary level when V_{sig} exceeds the target value, applying the digital signal to the digitally-gain-controlled amplifier and changing the gain of the digitally-gain-controlled amplifier in the direction to bring the peak values in V_{sig} to just below the predetermined target value. Finally a binary proximity-detector output voltage Vₒᵤₜ is generated having transitions of one polarity each time excursions of one polarity in V_{sig} reach a predetermined point therein.

It is preferable that the generation of Vₒᵤₜ be accomplished by a slope-activated proximity detector method such as those described in patent application Serial No. 08/587,405 entitled DETECTION OF PASSING MAGNETIC ARTICLES AT SPEEDS DOWN TO ZERO AND CIRCUIT THEREFOR or the above-noted patent U.S. 5,442,283.

The comparing the amplitudes of the excursions of at least one polarity in V_{sig}, and the generating a digital signal for incrementally changing the gain of the digitally-gain-controlled amplifier, may only be for one initial predetermined interval. Each incremental change in gain is preferably a fixed predetermined increment of gain change. There may be added the steps of counting the excursions of at least one polarity and terminating the one initial predetermined interval when the count reaches a predetermined number.

A method for detection of passing magnetic articles comprises sensing an ambient magnetic field and generating a voltage, V_{sig}, that is proportional to the magnetic field, converting positive slope portions only of the analog signal V_{sig} to a digital signal V_{Pcount}, converting the digital signal V_{Pcount} to a positive V_{sig}-tracking analog signal V_{DAC-P}, holding V_{Pcount} at each peak positive excursion in V_{sig}, and when at time tₚₚₖ after each positive peak in V_{sig}, V_{sig} has fallen below V_{DAC-P} by a predetermined amount, producing one detector pulse (V_{pcomp}) indicating the detection of approach of a passing magnetic article. The preferred method additionally includes converting negative slope portions only of the analog signal V_{sig} to a digital signal V_{Ncount}, converting the digital signal V_{Ncount} to a negative V_{sig}-tracking analog signal V_{DAC-N}, holding V_{Ncount} at each peak negative excursion in V_{sig}, and when at time tₙₚₖ after each negative peak in V_{sig}, V_{sig} has risen above V_{DAC-N} by a predetermined amount, producing another detector pulse (V_{ncomp}) indicating the detection of leaving of a passing magnetic article.

The method may be additionally comprised of, at time tₚₚₖ enabling starting the converting of the digital signal V_{Ncount} to a negative V_{sig}-tracking analog signal V_{DAC-N}, and at time tₙₚₖ starting the converting of the positive slope portions only of the analog signal V_{sig} to a digital signal V_{Pcount}.

The method may also include generating a binary output signal that at times tₚₚₖ changes to one binary level and that at times tₙₚₖ changes from the one to the other binary level, so that the binary output signal is at one level when the magnetic-field proportional signal, V_{sig}, has a positive slope and is at the other level when the magnetic-field proportional signal, V_{sig}, has a negative slope.

This invention also encompasses a proximity sensor of magnetic articles that includes a magnetic-field-to-voltage transducer for generating a signal, V_{sig}, that is proportional to the magnetic field. The transducer may for example consist of a Hall element followed by a Hall-voltage amplifier. One digital signal is generated by one transducer-voltage comparator (OTVcomp), a first circuit branch directly connects the output of the transducer and the one OTVcomp input, and a second circuit branch connected between the transducer output and another input of the OTVcomp.

The second circuit branch is for producing a binary detector output signal having a transition of one polarity at the time of the occurrence of a positive peak tₚₚₖ in V_{sig}, and toward doing so employs a positive peak detector (PPD) comprised of the one Schmitt comparator (OScomp) having one input connected via the first circuit branch to the transducer output, employs one digital-to-analog converter (P-DAC) that has an output connected to the another input of the OTVcomp, employs a clock that generates a stream of clock pulses, and employs one AND gate.

One counter has a count input connected to the output of the clock, and has a count enable input connected to the output of the OTVcomp via the one AND gate which entails the Of Vcomp output being connected to one of the one AND gate inputs. The one counter counts the clock pulses only when an enable signal at one binary level appears at the count enable input. The one counter counts the clock pulses only when V_{sig} has a positive slope. The P-DAC additionally tracks a positive slope portion of V_{sig} and holds the ensuing positive peak voltage of V_{sig} until a time tₚₚₖ at which V_{sig} recedes from the held positive peak voltage by an amount equal to the threshold Vhys of the OScomp. The pulse output from the OScomp comparator indicates the time of peaking of a positive pulse in the transducer signal V_{sig}. A reset signal generating means is connected to the output of the one OScomp which generating means has an output connected to the reset input of the counter for resetting the one counter at time tₚₚₖ.

In a further development of the detector circuit, the second circuit branch additionally includes a negative peak detector (NPD), that may be a mirror image circuit to the positive peak detector (PPD), and thus including another transducer-voltage comparator (ATVcomp), an N-DAC, another Schmitt comparator (AScomp) and another AND gate. The AScomp output is connected to the another input of the another AND gate to cause in the another Schmitt comparator output a transition of one polarity at the time of the occurrence of a negative peak tₙₚₖ in V_{sig}.

The NPD is further for disabling the one counter at the beginning of the next positive slope portion, and thereby causing the output of the P-DAC to go to zero. This permits the one counter to count and the P-DAC to track and hold the voltage V_{sig}, as before, during the next positive slope portion of V_{sig}. These features constitute synergy between the NPD and the PPD whereby the positive and negative tracking of V_{sig} is, during each period in V_{sig} , triggered by the NPD to begin in the PPD and visa versa.

The first and second digital signals generated in the clock during the tracking respectively of the positive and negative slopes in V_{sig} makes it possible to hold indefinitely the peak values in the counter, and thus in the P-DAC and the N-DAC, and therefore enables the proximity detector of this invention to detect the passing of magnetic articles at down to zero speeds, unlike in any of the prior art proximity detectors of the past half a century.

### BRIEF DESCRIPTION OF THE DRAWINGS

Figure 1 shows a block diagram of a first magnetic-article proximity detector of this invention.

Figure 2 shows a waveform of the Hall (transducer) voltage signal, during passage of four magnetic articles, superimposed on a waveform of the output voltage signal V_{P1} from the PDAC1.

Figures 3, 4, 5, 6, 7 and 8 are drawn to the same time scale as that of Figure 2.

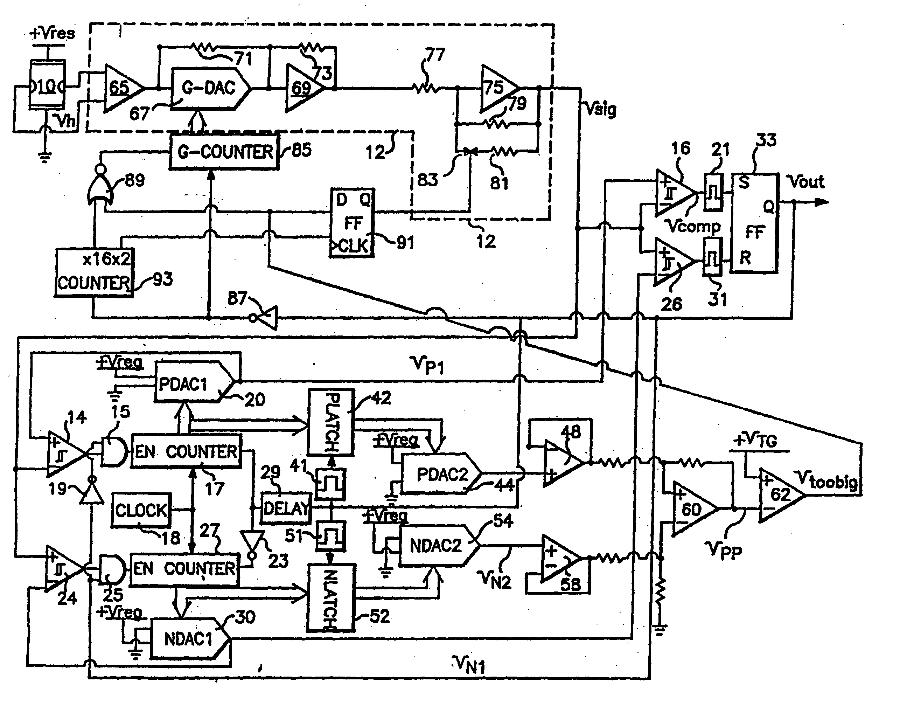

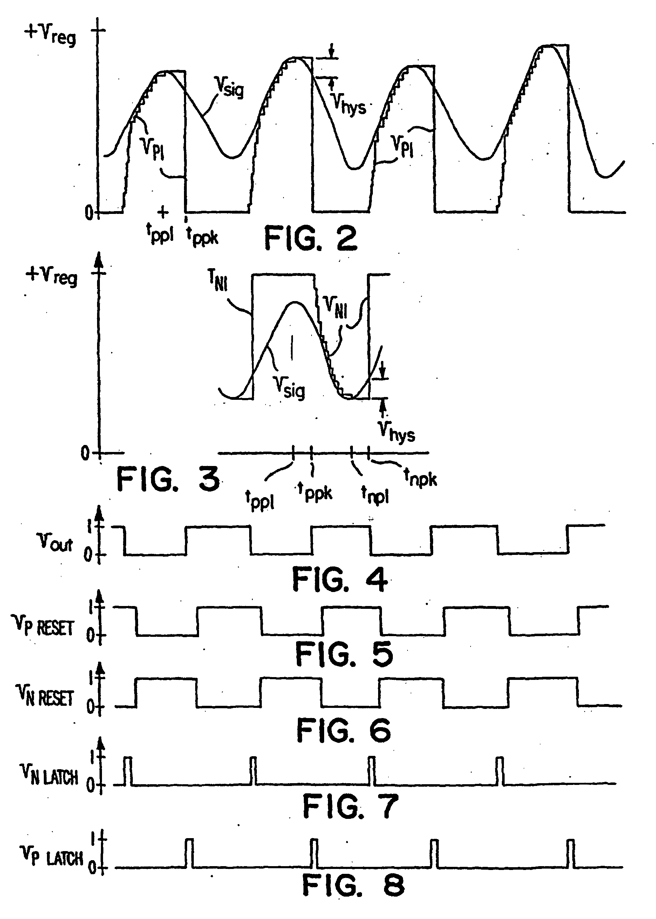

Figure 3 shows a partial waveform of the output voltage signal V_{N1} from the NDAC 1 in Figure 1.

Figure 4 shows a waveform of output voltage, Vₒᵤₜ, of the proximity-detector of Figure 1.

Figure 5 shows a waveform of the reset signal to the counter 17 in the proximity-detector of Figure 1.

Figure 6 shows a waveform of the reset signal to the counter 27 in the proximity-detector of Figure 1.

Figure 7 shows a waveform of the latch enable signal to the N latch 52 in the proximity-detector of Figure 1.

Figure 8 shows a waveform of the latch enable signal to the P latch 42 in the proximity-detector of Figure 1.

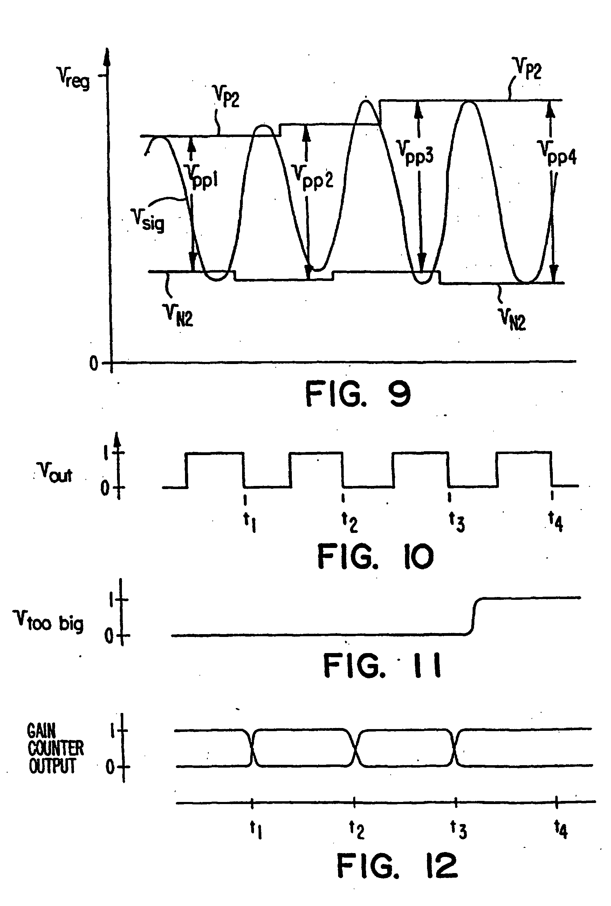

Figure 9 shows a waveform of the Hall (transducer) voltage signal, during passage of a few magnetic articles, having superimposed thereon the corresponding output signals V_{P2} and V_{N2} from PDAC2 and NDAC2 in the proximity detector of Figure 1.

Figures 10, 11 and 12 are drawn to the same time scale as that of Figure 9.

Figure 10 shows a corresponding waveform of output voltage, Vₒᵤₜ, of the proximity-detector of Figure 1.

Figure 11 shows a corresponding output signal waveform of comparator 62, V_{toobig}, in the proximity-detector of Figure 1.

Figure 12 shows corresponding waveforms of the binary output voltages from the first two bits in gain counter (G--COUNTER) 67 of the proximity-detector of Figure 1.

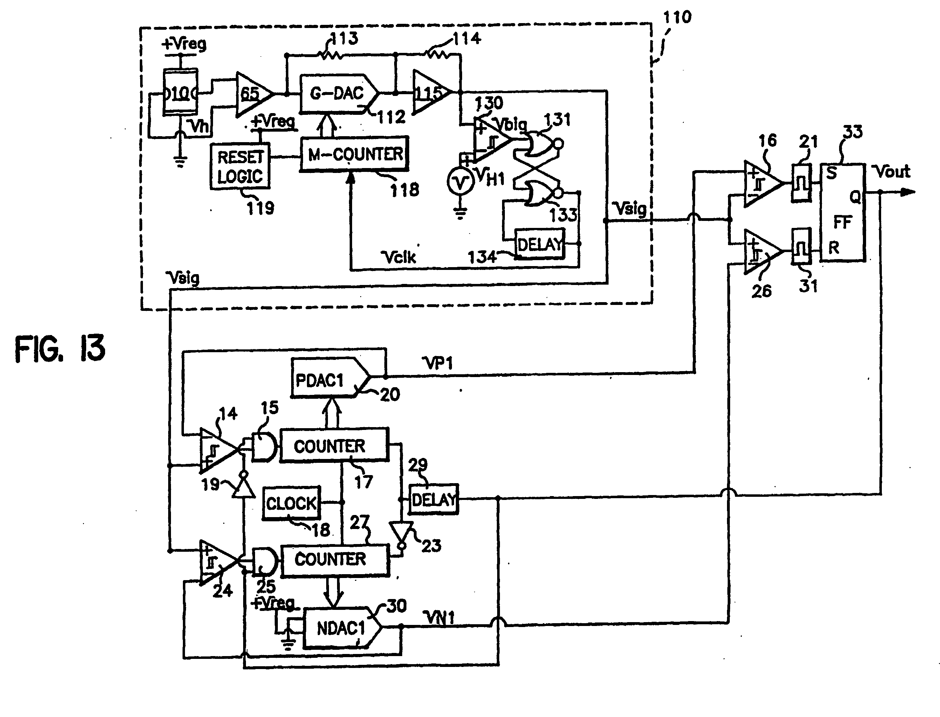

Figure 13 shows a block diagram of a second magnetic-article proximity detector of this invention.

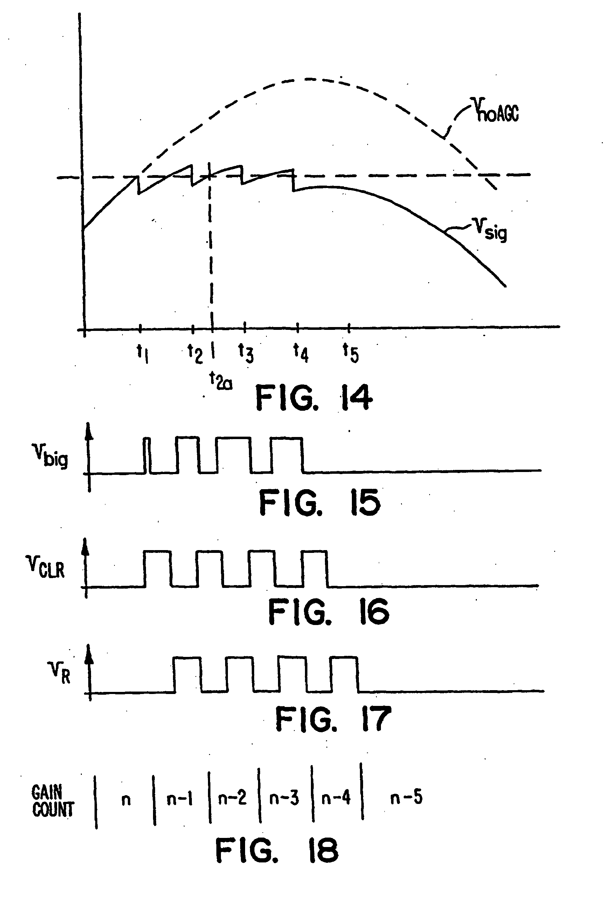

Figures 14, 15, 16, 17 and 18 relate to the proximity detector of Figure 13 and are all drawn to the same time scale.

Figure 14 shows the waveform of a positive peak portion of V_{sig} during which automatic gain control (AGC) is effected.

Figure 15 shows a waveform of the binary signal Vbig in the AGC circuit.

Figure 16 shows the waveform of the binary signal Vclk in the AGC circuit.

Figure 17 shows the waveform of the binary signal V_{R} in the AGC circuit.

Figure 18 shows the count in counter 118 which sets the gain of amplifier 110 for successive intervals during automatic gain control.

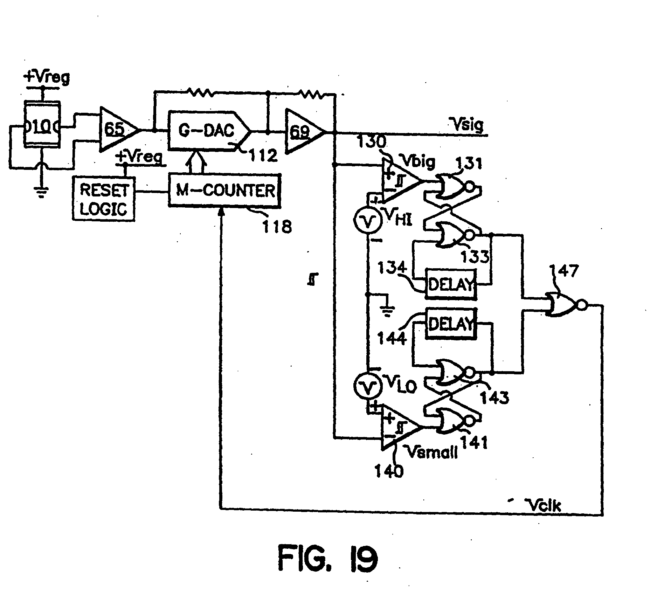

Figure 19 shows a block diagram of an alternative AGC circuit to that employed in the proximity detector of Figure 13.

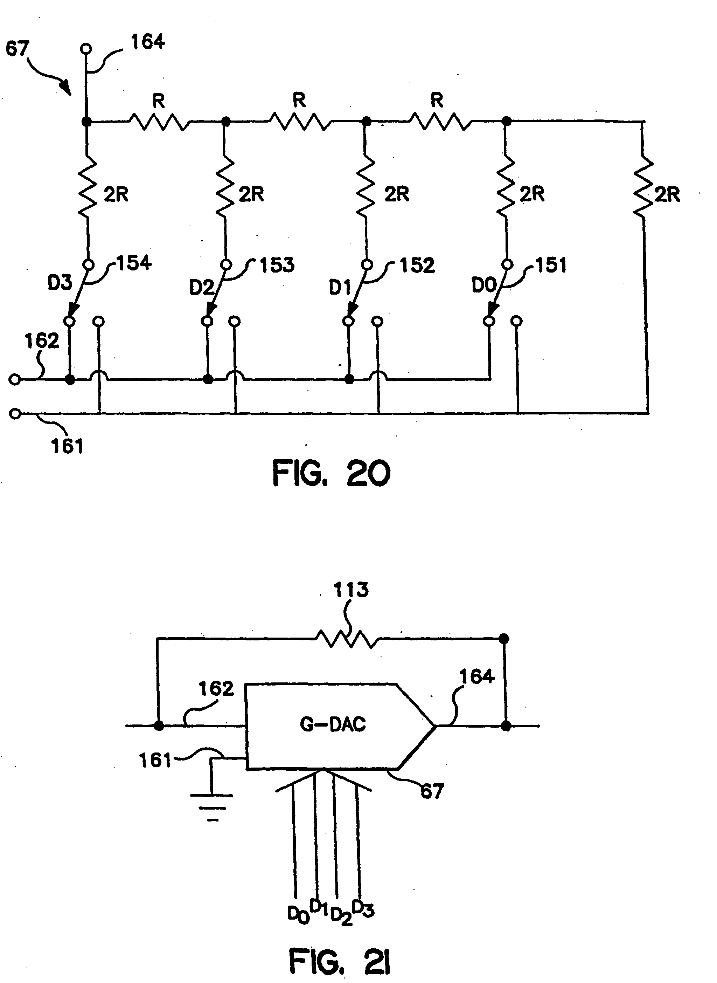

Figure 20 shows a circuit diagram of an R/2R digital-to-analog converter (DAC).

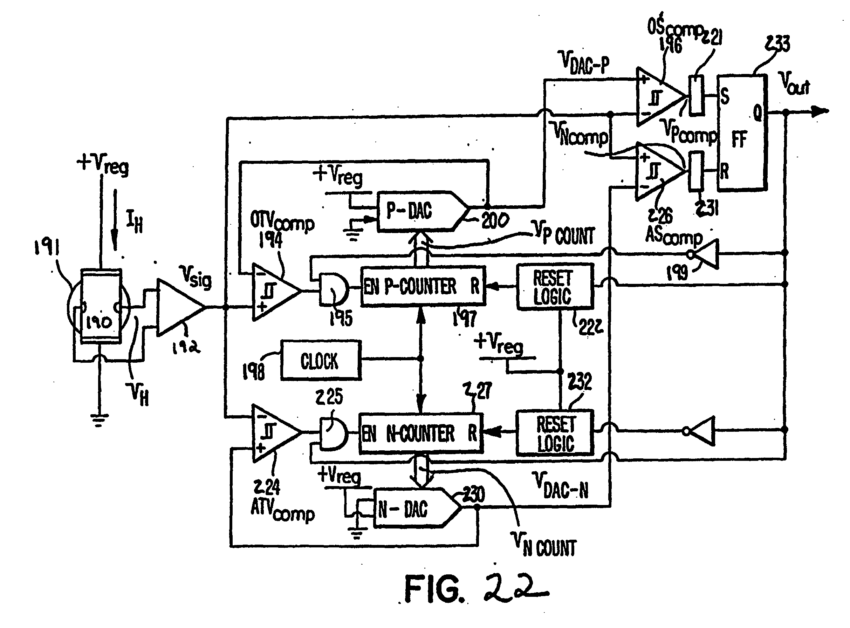

Figure 21 shows a block diagram 67 of the DAC of Figure 20 connected as a digitally controllable resistor, such as may be employed as the G-DAC 85 in Figures 1 and 19, and as the G-DAC 112 in Figure 13.

Figure 22 shows a block diagram of a first magnetic-article proximity detector of this invention.

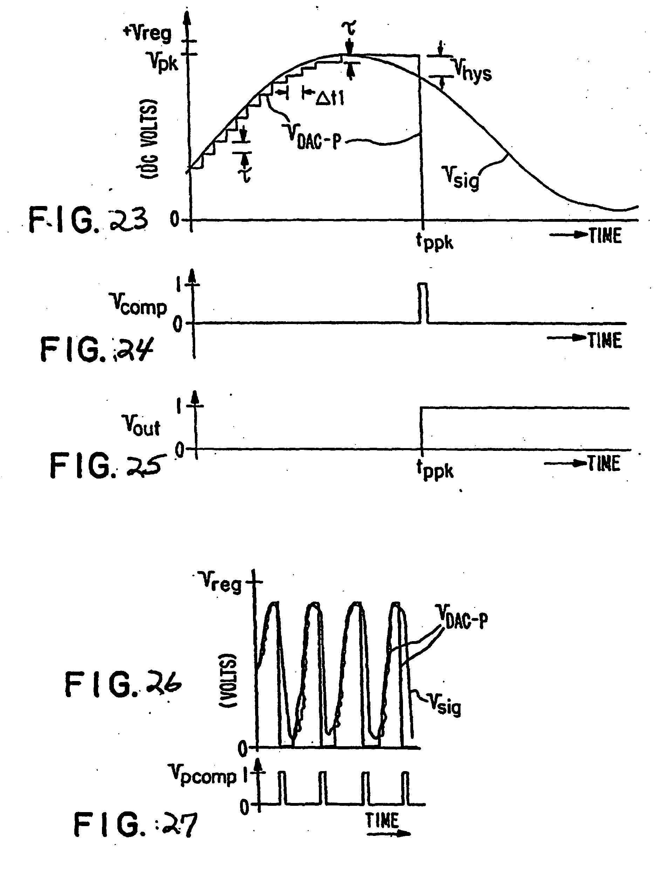

Figure 23 shows a waveform of the Hall voltage, V_{sig}, in the circuit of Figure 22 which waveform corresponds to the passage of one ferrous gear tooth (or other magnetic article).

Figure 24 shows the waveform of the output signal, Vcomp, from the comparator, OScomp, of Figure 22. Each pulse in Vcomp indicates the onset of the trailing edge of the single passing gear tooth. Figures 23 and 24 are drawn to the same time scale.

Figure 25 again shows a waveform of Vₒᵤₜ in the circuit of Figure 22.

Figure 26 shows the waveform of several periods in the amplified Hall voltage, V_{sig}, in the detector of Figure 22.

Figure 27 is drawn to the same scale as Figure 26 and shows the pulses in signal the Vcomp that correspond to the positive peaks in the Hall voltage V_{sig}.

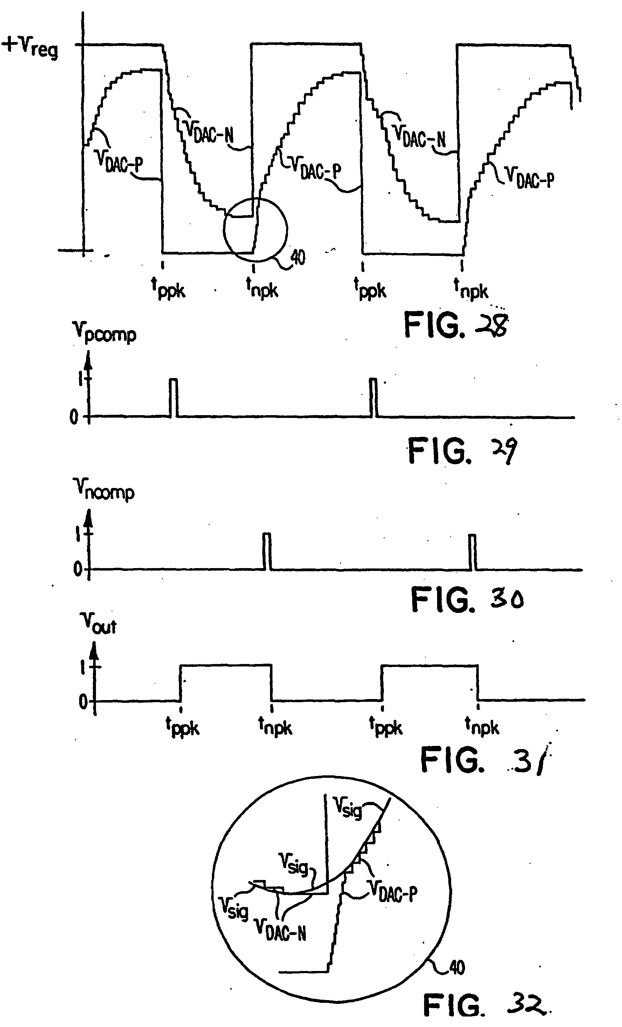

Figure 28 shows the waveform of V_{DAC-P} and V_{DAC-N} which respectively track and hold V_{sig}. (V_{sig} is not shown in the interest of clarity.)

Figures 29 and 30 show respectively the signals V_{pcomp} and V_{ncomp}, which are drawn to the same time scale as Figure 28.

Figure 31 shows the waveform of the output voltage signal, Vₒᵤₜ, in the proximity detector of Figure 1 and is drawn to the same scale as are the waveforms of Figure 28.

Figure 32 shows an enlarged view of the detail 40 in the waveforms of Figure 28.

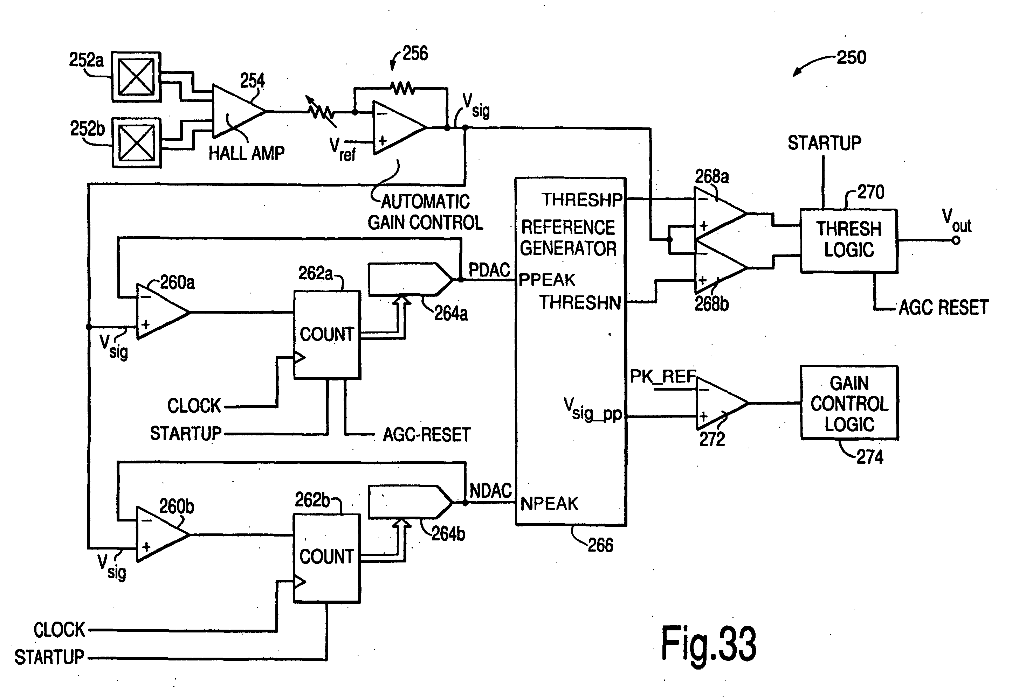

Figure 33 is a block diagram of a proximity detector which includes a peak-to-peak percentage threshold detector having a threshold logic circuit which allows the proximity detector to start in peak-to-peak percentage threshold mode and to operate in AGC mode;

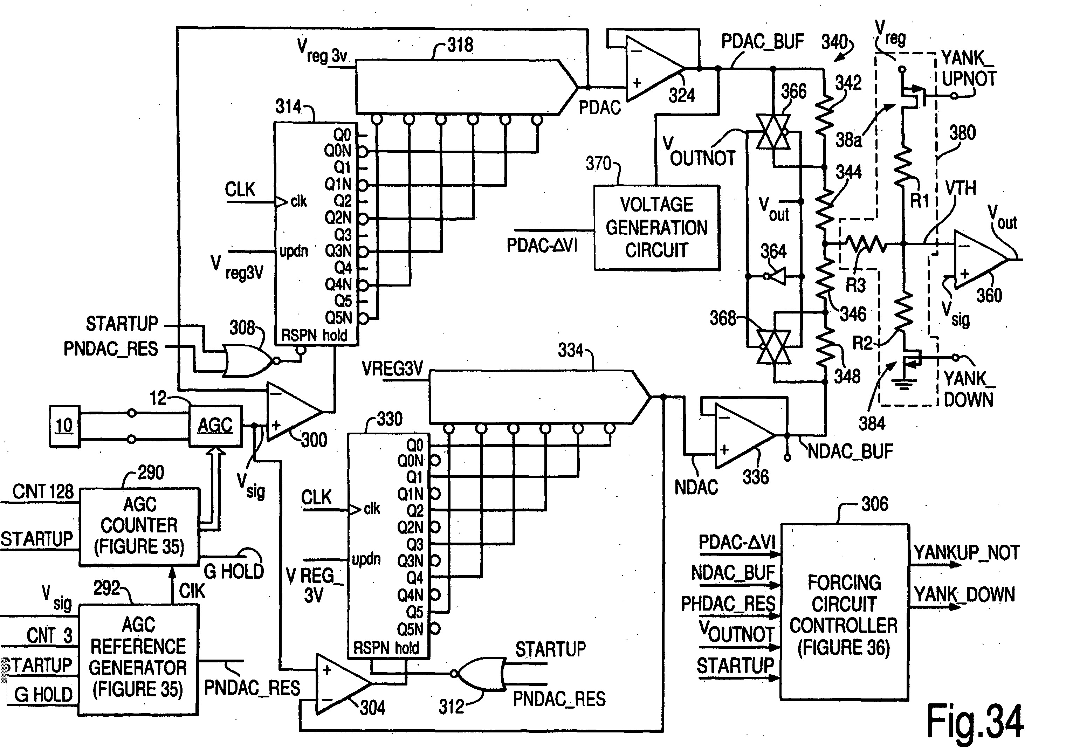

Figure 34 is a schematic diagram of a proximity detector which includes a forcing circuit;

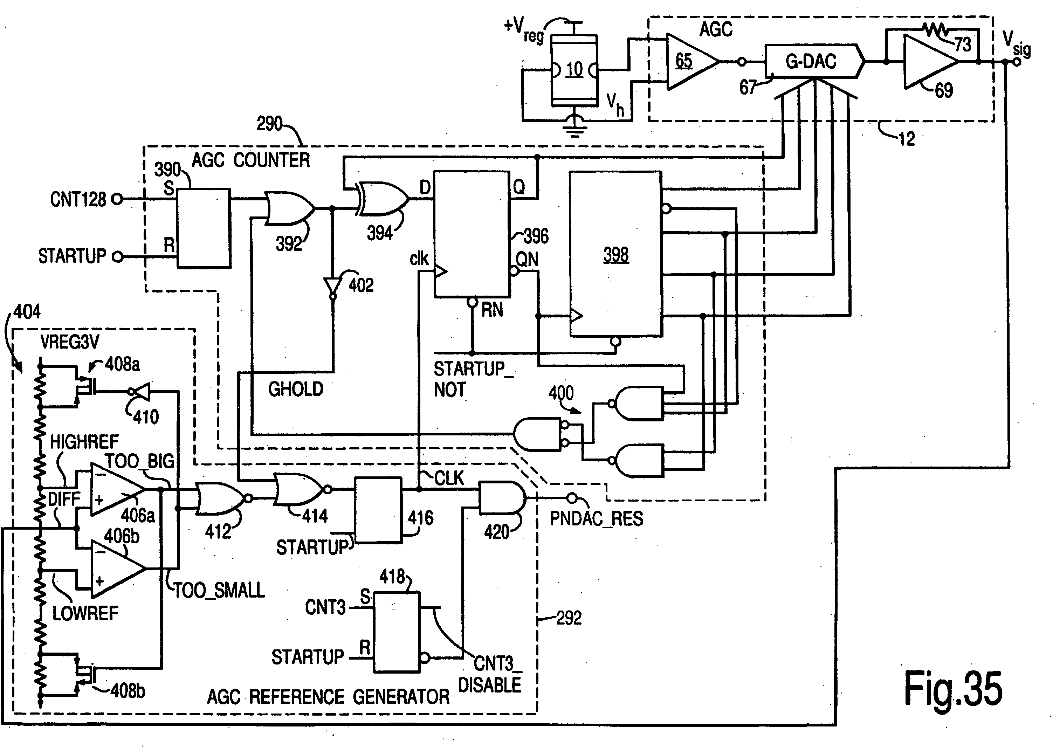

Figure 35 is schematic diagram showing an AGC portion of a proximity detector;

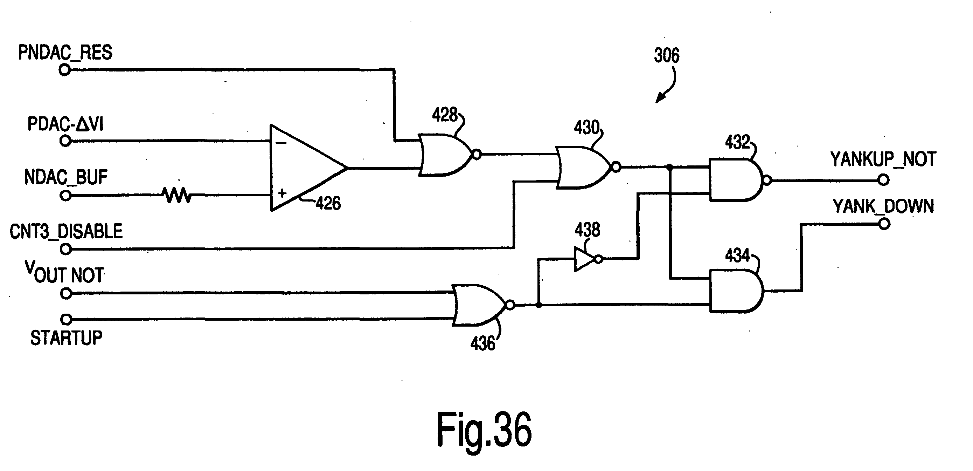

Figure 36 is a schematic diagram of a forcing circuit controller circuit; and

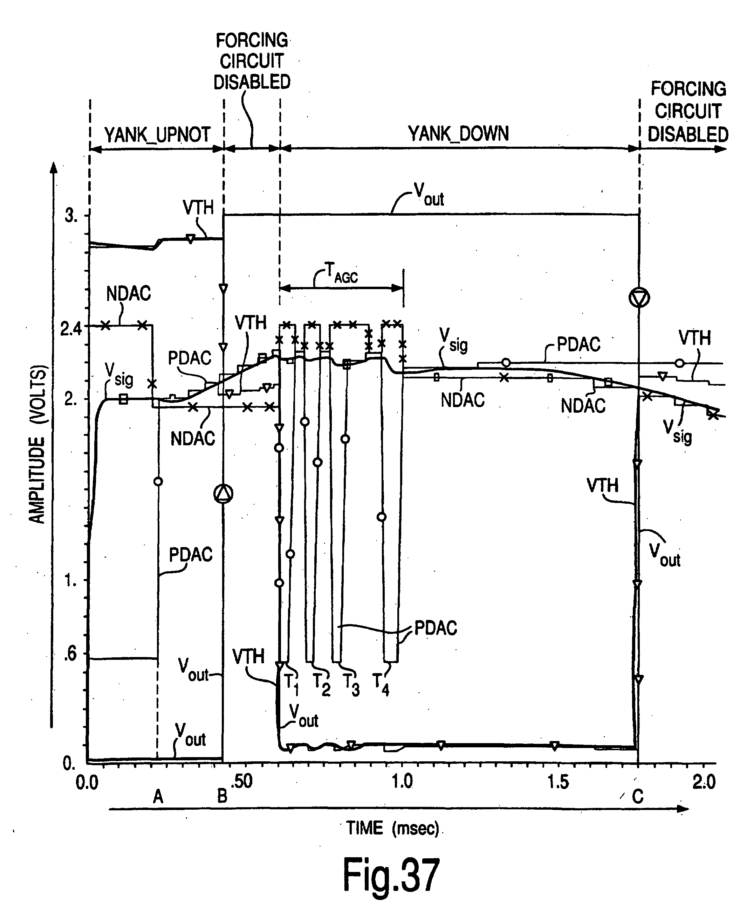

Figure 37 is a plot of amplitude versus time showing a comparator output signal, tracking signals PDAC and NDAC and a forcing circuit control signal.

### DESCRIPTION OF PREFERRED EMBODIMENTS

The Hall element 10 of Figure 1 has an output connected to the input of a Hall voltage amplifier 12. Hall element 10 may mounted at a pole of a magnet (not shown), so that when a ferrous article approaches, the Hall voltage V_{H} and thus the amplified Hall voltage V_{sig} increase (or decrease). When the article recedes, V_{H} and V_{sig} decrease (or increase depending upon the polarity of the magnet pole). Alternatively, the detector circuit of Figure 1 may be used to detect magnetic articles that themselves are magnetized, in which case the Hall element need not be mounted with a magnet.

A magneto resistors bridge (not shown) may be substituted for the Hall element. And two Hall elements with their outputs connected differentially to the input of the Hall voltage amplifier (not shown) represents a second alternative magnetic-field-to-voltage transducer.

The amplified Hall voltage, V_{sig}, is manipulated by the remaining circuits in the proximity detector of Figure 1 to produce a square wave proximity-detector output signal, Vₒᵤₜ, that like a shadow graph reflects the profile of the passing articles.

The amplified Hall voltage V_{sig} is applied to the positive input of a first comparator 14, and is also applied to the negative input of a second comparator 16. The amplified Hall voltage V_{sig} is further applied to the negative input of the other first comparator 24 and to the plus input of the other second comparator 26.

Assuming, as a starting point, that the counter 17 is at zero count, when the output of the first comparator 14 goes high the counter 17 begins counting the clock pulses from clock 18. The resulting count is presented to the digital-to-analog converter (PDAC1) 20 which produces an output analog voltage V_{P1} always lying somewhere within the range from zero to the DC supply voltage, +V_{reg}. At any instant the amplitude of V_{P1} is a direct linear function of the count signal from counter 17. When power is first applied to the detector circuit, a logic block (not shown) senses the time of turning on of the DC supply voltage, +V_{reg}, and resets the counters to zero count.

The comparator 14 has hysteresis and so is a Schmitt type comparator. The output of the DAC 20 (PDAC1) is connected to the negative input of the comparator 14 so that whenever V_{sig} becomes greater than voltage V_{P1} plus the small hysteresis threshold voltage of the comparator 14, then the comparator 14 output goes high. If at that time Vₒᵤₜ is low, then the outputs of inverter 19 and gate 15 go high and the counter 17 is enabled and counting. When V_{sig} is growing more positive, V_{P1} is caused to track V_{sig} in stair step fashion, as is illustrated in Figure 2. The incremental vertical excursions of the stair stepped V_{P1} are equal to V_{reg/2n}, where n is the number of DAC bits. The incremental horizontal times, Δt1, increase as the slope of V_{sig} decreases.

As is illustrated in Figure 2, when a peak positive voltage of V_{sig} is reached, the counter 17 stops counting at a time tₚₚ₁, and V_{P1} holds this peak voltage until time tₚₚₖ. At time tₚₚₖ, V_{sig} falls below the held voltage V_{P1} by an amount Vhys equal to the threshold of comparator 16, and the output of comparator 16 goes high briefly setting the flip flop 33 so that Vₒᵤₜ goes from low to high, as seen in Figure 4. The pulse expander circuits 21 and 31, shown as one-shot pulse generators in Figure 1, have their inputs respectively connected to the outputs of comparators 16 and 26, and have their outputs respectively connected to the set and reset inputs of flip flop 33.

Vₒᵤₜ is applied to the reset input of the counter 17 via a delay circuit 29, resetting and holding the count in counter 17 to zero at time tₚₚₖ (Figure 5) for as long as the reset signal V_{Preset} is high; thus V_{P1} remains at zero volts for that time also. At a subsequent positive pulse in the signal V_{sig}, V_{P1} again begins to track the subsequent positive pulse to its peak and to hold that new peak voltage. The reset signal (Figure 6) resets the counter 27 via inverter 23 at times tₙₚₖ and holds reset counter 27 for as long as the reset signal V_{Nreset} is high.

A lower (N) circuit portion in the proximity detector of Figure 1 essentially mirrors the construction of the upper (P) portion just described. The lower circuit portion manipulates the negative pulses in V_{sig} in the same way as does the upper portion with respect to positive pulses in V_{sig}. For example, as is illustrated in Figure 3, when a peak negative voltage of V_{sig} is reached, the counter 27 stops counting at a time tₙₚ₁, and V_{N1} holds this peak voltage until time tₙₚₖ. At time tₙₚₖ, V_{sig} falls below the held voltage V_{N1} by an amount Vhys equal to the threshold of comparator 26, and the output of comparator 26 goes high to reset the flip flop 33 so that Vₒᵤₜ goes from high to low, as seen in Figure 4.

The part of the proximity detector of Figure 1 described above operates in a digital peak detecting mode. Such a detector is the subject of a patent application Ser. No. 08/587,405, entitled DETECTION OF PASSING MAGNETIC ARTICLES AT SPEEDS DOWN TO ZERO, that is assigned to the same assignee as is the current application and is filed concurrently herewith. That application describes the proximity detector circuit and operation in greater detail and is incorporated by reference herein.

The remainder of the circuit in Figure 1 relates to circuitry for the automatic gain control circuit of the Hall voltage.

The count signals from counters 17 and 27 are also applied, via latches 42 and 52 respectively to PDAC2 44 and NDAC2 54. The P-latch 42 and N-latch 52 are enabled by signals V_{Platch} (Figure 7) and V_{Nlatch} (Figure 8) from one shot generators 41 and 51 respectively. The one shot generators 41 and 51 are triggered respectively by a low to high transition in the signal Vₒᵤₜ and by a high to low transition in Vₒᵤₜ (Figure 4). The output signals V_{P2} and V_{N2} from PDAC2 and NDAC2 are shown in Figure 9 as they relate to each other and to V_{sig}, and Vₒᵤₜ is drawn to the same scale in Figure 10.

Now to recapitulate, the output of comparators 24 and 26 go high only when V_{sig} goes negative. Thus only when V_{sig} is going negative are there changes of state in the signals of AND gate 25, counter 27, NDAC1 30, latch 52, NDAC2 54 and buffer 58. The upper (P) and lower (N) portions of the circuit share the clock 18, the reset delay circuit 29. Referring to Figure 3, this tracking of V_{sig} begins at a time tₚₚₖ at which a low to high transition in Vₒᵤₜ occurs.

Counters 17 and 27 only count upwardly. It should be noted that the DC reference voltages +V_{reg} and ground are connected to NDAC1 130 and NDAC2 54 inversely with respect to those connections to PDAC1 20 and PDAC2 44; therefore as the count in counter 27 goes up, the output V_{N1} of the NDAC1 30 goes down as seen in Figure 3. Alternatively, both of the NDACS 30 and 54 could have been connected to the DC reference voltages as are the PDACs 20 and 44 if the counter 27 had been of the kind that counts down from maximum count. The counters 17 and 27 are of the kind that include an anti-overflow feature that prevents wrapping of the count when maximum count is exceeded.

The signals V_{P2} and V_{N2} are applied via unity gain buffer stages 48 and 58 to the two inputs of a fixed-gain differential amplifier 60. The output signal of amplifier 60, Vₚₚ, is the difference voltage between V_{P2} and V_{N2}, which difference voltage is essentially equal to the peak to peak value of V_{sig}. As V_{sig} grows, it is tracked by Vₚₚ as seen in Figure 9.

The signal Vₚₚ is applied to one input of a comparator 62. A reference voltage V_{TG} is applied to the other comparator 62 input. When Vₚₚ exceeds V_{TG} the output signal V_{toobig} of comparator 62 is at a high binary level.

The Hall voltage amplifier 12 includes a fixed-gain amplifier stage 65; a programmable-gain amplifier composed of a digital-to-analog converter G-DAC 67, two resistors 71 and 73, and an operational amplifier 69; and a step-wise adjustable-gain amplifier composed of an operational amplifier 75; three resistors 77, 79 and 81, and a switch 83.

A counter 85 is an up counter which does not wrap after the maximum count is reached, and has a count output connected to the G-DAC 67. The signal Vₒᵤₜ is inverted by inverter 87, and counter 85 counts positive transitions in the inverted signal Vₒᵤₜ. G-DAC 67 is connected internally as a digitally programmable resistor having a maximum resistance when the input count to the DAC is zero. The resistance of the resistor 71 in parallel with the resistance of G-DAC 67 sets the total input resistance to the operational amplifier 69 at its highest value at zero count which sets the gain of the amplifier at its lowest value.

When the first positive and negative excursions in V_{sig} generate a signal Vₚₚ₁ (Figure 9) that is lower than the reference voltage V_{TG}, the signal V_{toobig} is low (Figure 11) and enables counter 85 via inverting NOR gate 89. Counter 85 responds by counting up by one count at the next positive transition in inverted signal Vₒᵤₜ as indicated in Figure 12. This causes a single increment of gain increase, which is illustrated in Figure 9 wherein Vₚₚ₁ grows to Vₚₚ₂ and V_{sig} increases slightly in amplitude in the period from t₁ to t₂. This process of testing the amplitude of (Vₚₚ and thus V_{sig}) against a target reference value V_{TG} and adjusting the gain upward one increment when the target has not yet been reached, continues for as many periods in V_{sig} (and Vₒᵤₜ) as is necessary to set the peak to peak amplitude of V_{sig} to the target value, V_{TG}.

When the target value has been reached or exceeded, V_{toobig} goes high (Figure 11), so the counter 85 being thus disabled does not count further as illustrated in Figure 12 and the gain of the amplifier remains fixed (e.g. between times t₃ and t₄ in Figure 9) thereafter (until the detector has been turned off and started up again).

However, when the first positive and negative excursions in V_{sig} generate a signal Vₚₚ₁ (Figure 9) that is higher than the reference voltage V_{TG} , the signal V_{toobig} is high for disabling counter 85 via inverting NOR gate 89, and holding the D input of the flip flop 91 high. Counter 93 is a serial counter that provides one output at which the signal is low until the counter has counted two (more generally a few) positive excursions in the inverted signal Vₒᵤₜ, at which time the inverter 87 output goes high and clocks through the high at the D input of flip flop 91 to the flip flop Q output.

This clocking of a high signal through flip flop 91 occurs when the non inverted signal Vₒᵤₜ (Figure 10) goes low. After the first two periods in V_{sig}, switch 83 closes to connect feedback resistor 81 which decreases the gain of the amplifier composed of operational amplifier 75 and resistors 77 and 79. For example, the operational amplifier gain may be reduced by a factor of 4, causing the gain of amplifier 12 to be reduced by a factor of 4.

Thus during the first two positive pulses in the transducer voltage V_{sig} it is determined whether the peak to peak voltage of V_{sig} (Vₚₚ) is too big relative to the target reference voltage V_{TG}. If it is not too big, the G-counter is enabled (by signal V_{toobig}), the resistance of G-DAC 67 immediately begins to fall and the gain of that count-controllable gain stage rises to the target value at which it remains thereafter.

But if during the first two positive pulses in the transducer voltage V_{sig} (corresponding to the passing of two magnetic articles), it is determined that the peak to peak voltage (Vₚₚ) of V_{sig} is too big relative to the target reference voltage V_{TG}, then after two pulses in V_{sig} the overall gain of amplifier 12 is reduced by a factor of 4, and the count-controllable gain stage brings the peak to peak value of V_{sig} up to the target value.

Counter 93 is a serial up-counter of the kind that does not wrap. It counts up only and is not reset until de-energized and again energized. Counter 93 provides a second serial count output that goes high at the larger count of 16 excursions (pulses) in V_{sig} (or Vₒᵤₜ). The x16 output is low until the count 16 has been reached. A high output signal from the x 16 output of counter 93 at the count of 16 disables the G-counter 85 to limit how many (e.g. 16) periods in V_{sig} (e.g. negative going excursions in V_{sig} and/or Vₒᵤₜ) may be counted by the G-counter 85 to adjust the gain. Alternatively, the counting of positive going excursions would be equally effective.

The purpose of effecting automatic gain adjustment, for only a few of the first pulses in V_{sig} following turning on the supply voltage +V_{reg} and starting the detection of passing articles, is to obtain optimum transducer-voltage amplifier gain for the conditions at starting and to maintain constant gain thereafter in order to avoid incremental shifts in the actual distance of approaching articles at which a corresponding transition in Vₒᵤₜ occurs. When gain changes take place continuously frequent shifts in detection approach distance cause jitter in the Vₒᵤₜ transitions.

In the above described embodiment, the gain of amplifier 12 is adjusted during the first 16 periods in V_{sig} (corresponding to the passage of the first 16 magnetic articles) and thereafter held fixed, providing a fast initial gain adjustment after which no further adjustments are made. This feature is particularly suitable in a proximity detector for use in a combustion engine ignition system, wherein all the adjustments in gain occur only during crank start of the engine. During the subsequent loading and running of the engine it is desired to avoid any changes in ignition timing that would occur as a result of changes in the amplitude of V_{sig}, and thus gain adjust is completed just at start.

To summarize, after just two articles have passed it is determined whether the signal is too big and if so the gain of amplifier 12 is reduced by a large factor, namely in this example by a factor of 4. And during passage of the following 16 articles, the gain is adjusted upward based upon the greatest of the peak amplitudes in the transducer signal V_{H}, so that greatest peak amplitude is at a predetermined target value. This target amplitude is just inside the dynamic range of the amplifier 12, avoiding clipping of the signal while at the same time providing a large signal V_{sig} with peaks just under the target value V_{TG} for enhancing accurate detection.

Referring to the second embodiment of a gain controlled proximity detector in Figure 13, the output of the Hall transducer 10 is connected to the fixed-gain Hall voltage amplifier 65 which is in turn connected to the input of a digitally controllable gain stage composed of a digital-to-analog converter G-DAC 112, two resistors 113 and 114, and an operational amplifier 115.

The counter 118 is a down counter which is reset to its maximum count by logic block 119 only when the proximity detector is started, namely when +V_{reg} is turned on. Counter 118 does not wrap after the unlikely event that the count has reached zero. The positive going transitions in clock signal Vclk correspond respectively to passage of magnetic articles by the transducer 10 as will be further described.

G-DAC 112 is connected internally as a digitally programmable resistor having a maximum resistance when the input count to the DAC is zero. This G-DAC resistor in parallel with resistor 113 sets the total input resistance Rᵢₙ to the operational amplifier 69 at its highest value when the counter 118 is at maximum count. The gain of this digitally controlled amplifier is R₁₁₄/Rᵢₙ, and at maximum count when Rᵢₙ is at its minimum value the amplifier gain is the greatest.

The amplified Hall voltage V_{sig} is applied to one input of comparator 130 and a DC reference voltage V_{HI} is connected to the other input of comparator 130. When as illustrated in Figure 14, a positive excursion in V_{sig} reaches the reference voltage V_{HI}, the signal V_{big} (Figure 15) at the output of comparator 130 goes high at time t₁. This causes the output Vclk (Figure 16) of the latch of cross-coupled NOR gates 131 and 133 to go high, and the count in counter 118 decreases by one. Thus at t₁ the resistance of G-DAC 112 goes up by an incremental amount, the gain of amplifier 110 decreases by a corresponding incremental amount and there is an incremental drop in the voltage V_{sig} that occurs at time t₁.

But the incremental drop in V_{sig} at t₁ puts the amplitude of V_{sig} below V_{HI} and Vbig almost instantaneously goes low as illustrated in Figure 15. Thus there is only a narrow high spike in the signal Vbig at t₁ as seen in Figure 15. The signal Vclk passes through the delay circuit 134 (e.g. a 5µsec delay), and at 5µsec after t₁ the reset input signal V_{R} (Figure 17) to NOR gate 133 goes high to reset the NOR gates latch.

Because the gain in amplifier 110 has dropped at t₁, V_{sig} is amplified less after t₁. When V_{sig} again reaches V_{HI}, Vbig goes high. But the high in V_{R} (Figure 17) holds the latch reset until t₂, at which time the high in Vbig can set the latch again and drop the gain of the amplifier 110 a second time. This sequence of events is repeated until at time t₄, V_{sig} remains below the reference voltage V_{HI}. The dashed curve V_{noAGC} in Figure 14 shows the waveform of the excursion of V_{sig} that would have occurred if the gain of the amplifier 110 had remained constant, i.e. there had been no automatic gain control.

In Figure 18, n is the gain setting count in counter 118 prior to time t₁. Successive counts (n-1) through (n-5) decrease leading to successive decreases in amplifier gain. If the following positive peaks in transducer signal V_{H} remain the same, the gain setting count in counter 118 will drop very little more if any. It can therefore be appreciated that AGC action will have been substantially terminated during appearance of the very first positive excursion in V_{sig} after energizing the proximity detector.

This also illustrates the ability of the detector of Figure 13 to count passing magnetic articles down to zero speeds and simultaneously obtain effective AGC action and the corresponding advantage of high detection accuracy from the very first positive excursion in V_{sig}.

The detector of Figure 19 consists of the detector of Figure 13 with the addition of AGC circuits for automatic gain control of a negative going excursion in V_{sig}. Although, considering that the detector of Figure 13 controls the gain of V_{sig} and therefore the amplitude of positive and negative peaks therein, and considering that it is not uncommon that magnetic-field-to-voltage transducers produce asymmetrical waveforms in V_{H}, it will be appreciated that it is possible in the detector of Figure 13, with AGC based on positive peaks only in V_{sig}, that negative peaks would be clipped.

The AGC circuit is expanded in Figure 19 to additionally include a negative peak comparator 140, a new fixed DC reference voltage generator V_{LO}, another latch of cross-coupled NOR gates 141 and 143, and another delay circuit 144.

These additional components are to provide complementary treatment of gain adjust referenced to the negative going excursions in V_{sig}. The added NOR gate 147 has inputs connected to the outputs of the two cross-coupled latches and produces a composite clock signal Vclk that is applied to the input of the down counter 118. Now if the first positive excursion in V_{sig} is greater than V_{HI}, the gain is adjusted downward. If a subsequent negative going excursion in V_{sig} is still less than V_{LO}, the gain is downward adjusted so that the peaks of both polarities in V_{sig} are within the range of from V_{LO} to V_{HI}, and asymmetrical waveforms in V_{H} of any extreme are quickly brought within the dynamic operating range of the amplifier by the AGC circuit of Figure 19.

The DACs 67 and 112 in Figures 1, 13 and 19 serve essentially as digitally-controllable resistors, and may employ the well known 2R/R type DACs connected as shown in Figure 20. Each of the three resistors shown at the top of Figure 20 has a resistance R, while the other four resistors have a resistance of 2R. The corresponding external leads of DAC 67 are shown both in the full circuit of Figure 20 and the block diagrammed DAC 67 in Figure 21.

A lead 161 is grounded while leads 162 and 164 are connected respectively to the output of the first Hall-voltage amplifier 65 and to the input of the operational amplifier 69. The four switches 151, 152, 153 and 154 represent electronic switches to which are connected the four digit count signal D₀, D₁, D₂ and D₃ from the gain counter (e.g. 85). Switches 151, 152, 153 and 154 are shown in the positions wherein all four digits in the input count signal are high and the resistance between leads 162 and 164 is at a minimum value. The paralleling resistor 113 is not essential. Resistor 113 drops the minimum resistance of the paralleled combination at the input of the operational amplifier but more importantly reduces the maximum operational amplifier input resistance, i.e. maximum Rᵢₙ.

When grounded the G-DACs become digitally-controllable voltage dividers, and the effective resistance between conductors 162 and 164 becomes essentially a linear function of the digital count to the G-DAC 67 when R is large enough that the resistance between terminals 161 and 162 is much larger than the output impedance of the Hall-voltage amplifier 65. Thus amplifier gain is a linear function of the count.

Many variations in the proximity detectors of this invention are now evident, some of which are as follows.

It will be recognized that during the tracking by V_{P1} of positive slope portions of V_{sig} by the proximity detector of Figure 1, the comparator 14, clock 18, counter 17 and PDAC 120 serve together as a generator of a digital signal, namely the digital count signal at the output of the counter 17, that is tracking V_{sig}. This digital signal generator is a digitizer of the analog signal V_{sig}, or is an analog-to-digital convertor. Likewise during tracking by V_{N1}, comparator 24, clock 18, counter 27 and NDAC 30 serve together as an analog-to-digital convertor producing a digital signal, namely the digital count signal at the output of the counter 27, that tracks negative going portions of V_{sig}. These remarks apply to Figure 13 as well. In proximity detectors of this invention, digital-to-analog convertors may be formed by circuit means other than those shown here.

For example, the digitally-gain-controllable amplifiers based upon use of G-DACs 67 and 112 may alternatively be based upon prior art digitally-gain-controlled amplifiers wherein there is substituted for the G-DAC a group of parallel connected branch circuits, each containing a resistor and a binary-signal controllable switch.

It is further possible to employ just one up-down counter (instead of the up counters 17 and 27) that would count up and down in response to a high binary signal respectively from comparators 14 and 24. In this case only one DAC, e.g. PDAC 120, may be used with the output connected to the positive and negative inputs respectively of comparators 16 and 26. The circuit portion in Figure 1 for generating the signal V_{toobig} may then be modified by connecting the up-down counter output to both latches 42 and 52, and enabling these latches during up counting and down counting respectively, e.g. using the signal Vₒᵤₜ as a latches enabling signal.

As noted, the purpose of effecting automatic gain adjustment, for only a few of the first pulses in V_{sig} to avoid incremental shifts in the actual distance of approaching articles at which a corresponding transition in Vₒᵤₜ occurs. In applications such as ignition distributors, the timing of engine firing tends to cause small but annoying jumps in engine power delivery. However, when detection accuracy is an overriding consideration, it is easily possible to periodically reset counter 93 (Figure 1) or 118 (Figure 13) to permit infrequent readjustments in gain, e.g. every minute or so, or after a predetermined number of detected articles have passed by.

Of course continuous gain adjustment is another option, e.g. accomplished in the detector of Figure 1 by removing the NOR gate 89 and connecting the Vtoobig signal directly to the enable input of the counter 85.

The Hall-amplifier output voltage V_{sig} may be considered a magnetic-field-to-voltage transducer output, which transducer includes the Hall element The above-described AGC is effected by controlling the gain of a digitally controlled Hall-amplifier that may be considered part of a transducer. Alternatively, it is possible to digitally control the exciting current in the Hall element for effecting AGC of the composite transducer, e.g. by using a digitally controlled voltage regulator that is used for energizing the Hall element.

It has been found through computer generated models, that proximity detectors of the kind described in the above-mentioned co-filed patent application Ser. No. 08/587,405 entitled DETECTION OF PASSING MAGNETIC ARTICLES AT SPEEDS DOWN TO ZERO may advantageously be merged with those of the kind described in patent application Ser. No. 08/587,407 entitled DETECTION OF PASSING MAGNETIC ARTICLES WHILE PERIODICALLY ADAPTING DETECTION THRESHOLDS TO CHANGING AMPLITUDES OF THE MAGNETIC FIELD.

Labeling these two kinds of proximity detectors respectively as "slope-activated" and "threshold" proximity detectors, a slope-activated detector was advantageously merged in a computer modeling simulation with a threshold detector. In the model, the merged detector became operative in the slope-activated mode for a short initial interval after starting, after which it automatically went into the threshold detection mode.

Furthermore the automatic gain control feature, that is the subject of this invention and is capable of operation down to zero speeds, was incorporated with the slope-activated detector for only initially setting the gain and the level of V_{sig}. Automatic gain control was thereafter discontinued to avoid further step-function gain shifts which tend to cause jitter and instability in the detection distances of magnetic article approach and departure. The method of automatic gain control of this invention is especially well suited for such initial use in a merged proximity detector because of its rapid gain adjustment and its undiminished detection efficacy at very low speeds.

Referring now to Figure 22, a Hall element 190 is energized by a current I_{H} and has an output connected to the input of a Hall voltage amplifier 192. Hall element 190 is mounted at a pole of a magnet 191, so that when a ferrous article approaches, the Hall voltage V_{H} and the amplified Hall voltage V_{sig} increase (or decrease); and when the article recedes, V_{H} and V_{sig} decrease (or increase depending on the polarity of the magnet pole). Alternatively, the sensor circuit of Figure 22 may be used to detect magnetic articles that themselves are magnetized, in which case the Hall element need not be mounted adjacent a magnet, e.g. the magnet 191.

A magneto resistors bridge (not shown) may be substituted for the Hall element. And two Hall elements with their outputs connected differentially to the input of the Hall voltage amplifier (not shown) represents a second alternative magnetic-field-to-voltage transducer.

The amplified Hall voltage V_{sig} is manipulated by the remaining circuits in the proximity detector of Figure 22 to produce an output logic signal, Vₒᵤₜ, having a profile that reflects the profile of the passing articles. This is partially accomplished by tracking the positive going portions of V_{sig} and detecting the next positive peak, which function is implemented by an upper portion of the circuit in Figure 22. This upper portion of the circuit and its function will be described first.

The amplified Hall voltage V_{sig} is applied to the negative input of a first comparator 194 via AND gate 195, and also is applied to the negative input of a second comparator 196. When the output of the first comparator 194 goes high the P-counter 197 begins counting the clock pulses from clock 198. The resulting count signal, V_{Pcount}, is presented to the digital-to-analog converter (DAC) 200 which produces an output analog voltage V_{DAC-P} lying within the range from zero to the applied DC voltage, +V_{reg}. Thus, at any instant the amplitude of V_{DAC-P} is a direct linear function of the applied count signal.

When power is first applied to the detector circuit, logic block 222 senses the time of turning on of the DC supply voltage, +V_{reg}, and resets the counter to zero count at startup.

The comparator 194 has a small hysteresis and so is a Schmitt type comparator. The output of the DAC 200 is connected to the negative input of the comparator 194 so that whenever V_{sig} is greater than voltage V_{DAC-P} plus the small hysteresis threshold voltage of the Schmitt comparator 194, then the comparator 194 output is high and the P-counter 197 is enabled and counting. When V_{sig} is growing more positive, V_{DAC-P} is caused to track V_{sig} in stair step fashion, as is illustrated in Figure 23. The incremental vertical excursions of the stair stepped V_{DAC-P}, τ, are equal to the least significant bit of the DAC (in millivolts) while the incremental horizontal times Δt1 increase as the slope of V_{sig} decreases. The hysteresis threshold of Schmitt comparators 194 and 224 are smaller than the incremental excursions respectively in V_{DAC-P} and V_{DAC-N}, so have no effect on the size of those excursions.

When the peak voltage of V_{sig} is reached, the P-counter 197 stops counting and V_{DAC-P} holds this peak voltage Vpk until time tₚₚₖ. At time tₚₚₖ, V_{sig} has dropped below the peak held voltage by an amount equal to the threshold voltage, Vhys, of the second Schmitt type comparator 196. At time tₚₚₖ the output of the second comparator 196 V_{pcomp} briefly goes high, as seen in Figure 24 and sets the flip flop 233 causing the Q output of flop 233 to go high as seen in Figure 25.

The Q output of comparator 233 is connected to the reset input of the P-counter 197 via logic block 222. Logic block 222 generates a reset pulse that resets the counter 197 to zero count, only at the occurrence of a low-to-high transition in the signal Vₒᵤₜ. This causes the output voltage of the DAC, V_{DAC-P}, to drop to zero volts which terminates the high output pulse in the signal V_{pcomp}.

This comparator output pulse, V_{pcomp}, tends to be very narrow and it may be desirable to employ a logic block 221 in the connection from the output of the second comparator 196 to the input of the flip flop 233 for increasing the pulse width toward providing greater reliability of the logic functions.

Figures 26 and 27 show the repetitive nature of the output signal V_{sig} that follows in a gear tooth sensing application, wherein the positive peaks in V_{sig} may correspond to the passing of successive gear teeth, and a pulse appears in the comparator output voltage V_{pcomp} just after each occurrence (tₚₚₖ) of a positive peak voltage in V_{sig}, and in each such successive instant the signal Vₒᵤₜ goes high.

At each such occurrence (tₚₚₖ), it is necessary to disable the P-counter 197 to keep it inactive during the subsequent negative slope portion of the amplified Hall voltage V_{sig}. This is accomplished by connecting the output of flip flop 233 to the second input of AND gate 195 via inverter 199.

V_{sig} is shown in Figures 23 and 26 as having broad peaks to provide a clear picture of the relationship between V_{sig} and V_{DAC-P}. In most practical situations, the magnetic articles to be detected have a geometry and a path of approach to the Hall element so that the Hall voltage V_{H} and V_{sig} have a more nearly square waveform than the broadly rounded peaks signal V_{sig} shown in Figures 23 and 26.

For the more typical flat topped V_{sig} signal (not shown), the counter reset time tₚₚₖ occurs essentially at the end of the peak in the amplified Hall voltage, V_{sig}, which corresponds to the beginning of the ensuing downward slope of V_{sig}, which for example may further correspond to the beginning of a trailing edge of a passing gear tooth.

In a prior art slope-activated detector, as the speed or rate of the passing magnetic articles goes lower and lower, in a fixed time scale V_{sig} appears more and more rounded (since it cannot have been perfectly square) to the point where the rate of decay in the held peak voltage approaches the slope of V_{sig} just after a peak. In a prior art detector, this slow speed condition results in the difference signal at the comparator input not being able to exceed the hysteresis of the comparator and no output pulses are generated at low speeds.

On the other hand, in the present invention the P-counter 197 holds a count at the peak which causes the DAC 200 to hold the peak voltage indefinitely, waiting even hours or days, until the difference in the two signals V_{sig} and V_{DAC-P} reaches Vhys, and thus enabling detection right down to a zero rate of passing articles.

The above description is to of a part of the proximity detector circuit (Figure 22) that tracks and holds the peak of positive going (positive slope) portions of the amplified Hall voltage signal, V_{sig}.

That description is yet missing the means for (a) terminating a time interval after tₚₚₖ in which the P-counter 197 is disabled, and for (b) changing Vₒᵤₜ from high to low again. These functions depend upon the yet to be described part of the proximity detector of Figure 22 which also tracks and holds the negative going (negative slope) portions of the amplified Hall voltage signal, V_{sig}.

In the dual polarity detector of Figure 22, the negative going portions of V_{sig} are tracked and held at the negative peaks by the additional components: a first comparator 224, AND gate 225, N-counter 227, DAC 230, pulse expander circuit 231, and second comparator 226. These components are functionally complimentary to the above-described components, respectively the first comparator 194, AND gate 195, counter 197, DAC 200, pulse expander circuit 221, and second comparator 196, which track and hold the peak of the positive going portions of V_{sig}.

The negative input of first comparator 224 is connected to the output of Hall voltage amplifier 192. Logic block 232 generates a reset pulse that resets the N-counter 227 to zero count, only at the occurrence of a high-to-low transition in the signal Vₒᵤₜ.

The performance of the dual peak detecting proximity detector of Figure 22 is indicated in Figures 28 through 32. In Figure 28, V_{DAC-P} is shown tracking V_{sig} during positive slope portions of V_{sig}. For clarity, the amplified Hall signal, V_{sig}, is not drawn in here. V_{DAC-N} is shown tracking V_{sig} during negative slope portions of V_{sig}.

The output signal, Vₒᵤₜ, (Figure 31) is a square wave that is low during times when the amplified Hall voltage, V_{sig}, has a positive slope and is high when the amplified Hall voltage, V_{sig}, has a negative slope.

Vₒᵤₜ is thus a slope-polarity indicator and is applied directly to an input of the AND gate 195 to enable counting ofN-counter 227 only during times when the slope of V_{sig} is negative and at negative peaks. On the other hand, Vₒᵤₜ is applied to an input of the AND gate 195 through inventer 199 to enable counting P-counter 197 only during times when the slope of V_{sig} is positive and at positive peaks. The output signal of the second comparators 226 is connected to the set inputs of flip flop 233.

The proximity sensor of Figure 22 provides dual polarity peak detection leading to the capability for generating a square-wave output signal, Vₒᵤₜ, having a profile that corresponds to that of passing gear teeth and the like. A peak detecting proximity detector of including essentially the same construction and operation is described in somewhat different terms in the patent application, Serial No. 08/587,407, entitled DETECTION OF PASSING MAGNETIC ARTICLES WHILE PERIODICALLY ADAPTING DETECTION THRESHOLDS TO CHANGING AMPLITUDES OF THE MAGNETIC FIELD. Another patent application Serial No. 08/587,406, entitled DETECTION OF PASSING MAGNETIC ARTICLES WITH AUTOMATIC GAIN CONTROL describes a similar analog-to-digital convertor followed by an analog to digital convertor for tracking and holding V_{sig}. These two applications are assigned to the same assignee, and are incorporated herein by reference to provide a fuller description.

Referring now to Figure 33, a magnetic article proximity detector 250 capable of initially starting in a peak-to-peak percentage threshold detection mode includes a pair of Hall elements 252a, 252b connected differentially to the input ports of a Hall amplifier 254. Hall elements 252a, 252b convert a differential magnetic field into electrical signals which are provided to input ports of an amplifier 254 as shown.

In this particular embodiment, the two Hall elements 252a, 252b are shown. Those of ordinary skill in the art will appreciate, however, that the two Hall elements 252a, 252b may equivalently be replaced by a single Hall element. Alternatively still, Hall elements 252a, 252b may be replaced by a magneto resistive bridge.

An amplified signal is coupled from an output port of amplifier 254 to a first port of an optional automatic gain control circuit (AGC) 256. A second input port of AGC 256 is coupled to a reference signal voltage V_{REF} and AGC 256 provides a signal voltage V_{sig} at an output port thereof. The amplitude of signal voltage V_{sig} varies in accordance with the strength of the magnetic field detected by Hall elements 252a, 252b.

AGC circuit 256 amplifies the signal provided thereto with a gain which varies in accordance with one of a plurality of available AGC algorithms such that the peak-to-peak signal amplitude of the signal voltage V_{sig} remains substantially constant over a relatively wide range of air gaps between the Hall elements 252a, 252b and the magnetic article detected by the Hall elements. It should be noted that AGC 256 is not required to allow proximity detector circuit 250 to initially begin operation in peak-to-peak percentage threshold detection mode.

The AGC 256 provides the signal voltage V_{sig}, to positive input ports of a first pair comparators 260a, 260b. Outputs of comparators 260a, 260b are coupled to respective ones of counter circuits 262a, 262b. Counter circuits 262a, 262b are each coupled to receive a clock signal CLK and a startup signal STARTUP.

Comparator 260a, count circuit 262a and DAC 264a form a first tracking circuit which receives the signal voltage, V_{sig}, and generates at an output port thereof a signal voltage PDAC, that tracks the highest peak of the signal voltage V_{sig}. Similarly, comparator 260b, count circuit 262b and DAC 264b form a second tracking circuit which also receives the signal voltage, V_{sig}, and generates at an output port thereof a signal voltage NDAC, that tracks the lowest peak of the signal voltage V_{sig}.

The PDAC and NDAC signal voltages are coupled from the output ports of the respective ones of the first and second tracking circuits to a reference generator circuit 266. Reference generator 266 includes a resistor divider coupled between the output ports of the DACs 264a, 264b. Thus the signal voltages PDAC and NDAC are coupled to the resistor divider to generate signal threshold voltages THRESHP and THRESHN in reference generator circuit 266.

The threshold signal voltages THRESHP and THRESHN are coupled to respective first inputs of respective threshold comparators, 268a, 268b. The signal voltage V_{sig} is coupled to the other inputs of comparators 268a, 268b.

The output ports of threshold comparators, 268a, 268b are coupled to respective input ports of a forcing circuit 270. In response to one of a signal STARTUP and a signal AGC_RESET, forcing circuit 270 forces output signal voltage Vₒᵤₜ to a predetermined value and maintains the output signal voltageₒᵤₜV at the predetermined value to prevent the output from false switching during an initial startup interval of the proximity detector 250 and when the proximity detector 250 engages the AGC.

Reference generator 266 also generates a signal V_{sig}_pp which is coupled to an input of comparator 272. A second signal voltage PK_REF is coupled to a second input of comparator 272. An output of comparator 272 is coupled to a gain control logic circuit 274 which determines when AGC should occur.

Proximity detector 250 operates in the following manner. At initial startup, the signal STARTUP is provided to count circuits 262a, 262b and forcing circuit 270. In response to the signal STARTUP, count circuit 262a sets the output of DAC 264a to a value which is lower than the least positive expected value of the signal voltage V_{sig} such as a voltage level close to or equal to the negative rail voltage for example. Similarly, in response to the signal STARTUP, count circuit 262b sets the output of DAC 264b to a value which is greater than the least negative expected value of the signal voltage V_{sig} such as a voltage level close to or equal to the positive rail voltage for example.

Setting the DAC 264a to a value which is lower than the least positive expected value of the signal voltage V_{sig} ensures that the DAC 264a will capture the positive peak of the signal V_{sig} even if the signal V_{sig} includes a relatively large offset voltage. Similarly, setting the DAC 264b to a value which is greater than the least negative expected value of the signal voltage V_{sig} ensures that the DAC 264b will capture the negative peak of the signal Vsig even if the signal Vsig includes a relatively large offset voltage.

Thus, during initial startup, the value of NDAC is more positive than the value of PDAC. As the first tracking circuit acquires the positive peak, and the second tracking circuit acquires the negative peak, the values of PDAC and NDAC will invariably cross each other, and at one instant in time, the output signal voltages PDAC, NDAC from the two DACs 264a, 264b will be equal. The threshold voltages THRESHP, THRESHN will be equal to each other and to the output signal voltages PDAC, NDAC.

Under these conditions, the output signal Vₒᵤₜ would normally switch. The forcing circuit 270, however, forces and maintains the output signal Vₒᵤₜ at a predetermined voltage level until the value of PDAC becomes greater than the value of NDAC by a predetermined voltage level. The forcing circuit 270 may be provided, for example, from a switch circuit which couples the output signal path on which Vₒᵤₜ appears to a predetermined voltage. Alternatively, forcing circuit 270 may be provided from one or more combinatorial logic circuits. Alternatively, still, forcing circuit 270 may be provided from a combination of digital and analog switch and combinatorial logic circuits.

Regardless of the particular devices included in forcing circuit 270, circuit 270 prevents the output signal voltage Vₒᵤₜ from improperly switching due to the value of PDAC being reset to a value which is lower than the value of NDAC. The forcing circuit 270 also prevents switching of the output signal voltage until the value of PDAC exceeds the value of NDAC by a predetermined voltage to thus minimize the chance of the output signal voltage switching due to noise, internal hysteresis of comparators and tolerances of circuits included in the proximity detector 250.

If AGC were not employed in the proximity detector 250, the above condition would happen only once, at initial startup. If AGC is employed in the proximity detector and the AGC function is activated, the peak to peak value of the signal changes almost instantaneously due to the change in gain. When this happens, the DACs 264a, 264b will no longer be holding the correct value of the peaks, and the signal could decrease because of AGC to the point where it will no longer cross the thresholds of the peak-to-peak percentage threshold detector. Thus the circuit will simply stop switching.

Even if such an event does not occur, because the threshold voltages THRESHP, THRESHN are generated from PDAC and NDAC, which no longer represent the actual positive and negative peaks of the magnetic signal, the timing accuracy will suffer since the threshold voltage levels THRESHP, THRESHN will no longer be in the correct location relative to the actual peak to peak electrical signal.

To overcome these problems, each time AGC is engaged, a signal AGC_RESET is generated and provided to count circuits 262a, 262b which resets the two DACs 264a, 264b such that the values of PDAC and NDAC are set to values close to respective ones of the negative and positive rail voltages as described above. In normal operation of proximity detector 250, PDAC tracks the value of the positive peak of the signal V_{sig} and NDAC tracks the value of the negative peak of the signal V_{sig}. Thus, under normal operating conditions of proximity detector 250, the value of PDAC exceeds the value of NDAC.

By setting the PDAC and NDAC values to their reset values as described above, the value of PDAC becomes less than the value of NDAC. This change in the relative amplitude relationship of PDAC and NDAC would cause the output signal voltage Vₒᵤₜ to change state. Thus, when the DACs 264a, 264b are reset, the output signal voltage Vₒᵤₜ must be reinforced in its present binary state to thus prevent the switching of output signal voltage Vₒᵤₜ due to the values of PDAC and NDAC being reset.

After the PDAC, NDAC values are reset, the tracking circuits reacquire the new positive and negative peaks, respectively, of the signal V_{sig}. While the tracking circuits are reacquiring the new peaks, the value of PDAC will become greater than the value of NDAC. Thus, the output signal voltage Vₒᵤₜ must continue to be reinforced until such time as the value of PDAC becomes greater than the value of NDAC so that the output signal voltage Vₒᵤₜ will not switch as the output signal amplitudes PDAC, NDAC of the DACs 264a, 264b cross each other while moving to their reset values, and while the tracking circuits reacquire the peak values of the signal V_{sig}.

The reinforcement is accomplished by the forcing circuit 270 forcing the output signal voltage Vₒᵤₜ to a predetermined value until such time that a minimum predetermined voltage change is detected in the signal voltage V_{sig}. The minimum predetermined voltage may be provided, for example, as a voltage having an amplitude greater than a voltage related to an internal hysteresis voltage of the threshold comparators 268a, 268b. Once the value of PDAC is greater than the value of NDAC, in response to comparator 426 detecting a voltage change in the signal voltage V_{sig} which is greater than a voltage corresponding to the minimum predetermined voltage, the forcing circuit 270 discontinues forcing the output voltage Vₒᵤₜ to a predetermined value and allows the output voltage V to switch in accordance with signal voltages provided to the threshold detectors 268a, 268b.

Referring now to Figure 34, an alternate embodiment of a magnetic-article proximity detector is shown. The detector includes the Hall element 10 providing a Hall voltage to an optional automatic gain control circuit 12 which in turn provides an amplified Hall voltage, V_{sig}, as described above in conjunction with Figures 1, 13 and 22. The detector of Figure 34 is operative to produce a binary square-wave output signal, Vₒᵤₜ, at a first binary level when V_{sig} rises to exceed a threshold voltage and another binary level when V_{sig} falls below the threshold voltage. In the embodiment of Figure 34, a single threshold voltage, VTH, is provided with hysteresis.

In the embodiment of Figure 34, the threshold voltage is a percentage of the peak-to-peak voltage of V_{sig} and is updated to remain the percentage, within a predetermined tolerance, of the V_{sig} voltage. Accordingly, the detector can be descriptively referred to as peak-to-peak percentage threshold detector. In the embodiment of Figure 34, the VTH threshold voltage is at a first level corresponding to a first percentage of V_{sig} when V_{sig} exceeds the threshold voltage and is at a second level corresponding to a second percentage of V_{sig} when V_{sig} is less than the threshold voltage (i.e., the threshold voltage VTH is provided with hysteresis).

It will be appreciated by those of ordinary skill in the art, and is within the scope of this invention, that the detectors described herein may be implemented in the form of, or to include, mid-signal detectors in which the threshold voltage is a fixed percentage of the V_{sig} voltage or peak-referenced (i.e., slope-activated detectors). As one example, the peak-to-peak percentage threshold detectors may include a peak-referenced detector such that the detector output signal Vₒᵤₜ becomes one binary level when V_{sig} rises to exceed a held negative peak excursion by a predetermined amount and another binary level when V_{sig} falls to below a held positive peak excursion by a predetermined amount

The V_{sig} voltage is applied to the negative input of a first comparator 300 and to the positive input of a second comparator 304. The output signals of comparators 300 and 304 are coupled to respective ones of HOLD inputs of counters 314, 330. The output of counters 314, 330 are held constant (i.e., the counter is disabled) when the HOLD input signal is at a first logic level and is released (i.e., the counter is enabled) when the HOLD input signal is at the second logic level. In the illustrative embodiment, the counters 314, 330 are six bit counters which are enabled when the HOLD input is low.

A reference voltage VREG3V is applied to an UPDN input of counters 314, 330 and thus in this particular example counters 314, 330 count only in one direction, e.g. in the up direction. Those of ordinary skill in the art will appreciate of course that a control signal could be provided to the UPDN input of counters 314, 330 in order to control the count direction. Counters 314, 330 are each clocked by a system clock signal, CLK.

A pair of NOR gates 308, 312 each receive a signal STARTUP on a first input thereof and a signal PNDAC_RES on a second input thereof. The signal PNDAC_RES is provided by an AGC reference generator 292 described below in conjunction with Figure 35. The outputs of NOR gates 308, 312 are coupled to respective ones of RESET ports of counters 314, 330. The output of counters 314, 330 are set to a first predetermined value when the RESET input signal is at a first logic level. Specifically, upon initial startup the signal STARTUP has high logic level thus causing NOR gates 308, 312 to produce a logic low output thereby causing counters 314, 330 to provide a first predetermined output value. Similarly, when AGC is engaged, the signal PNDAC_RES has high logic level thus causing NOR gates 308, 312 to produce a logic low output again causing counters 314, 330 to provide a first predetermined output value.

The outputs of the counter 314 are coupled to inputs of a Positive Digital-to-Analog Converter (PDAC) 318. The output of the PDAC 318 provides a voltage, PDAC, which is used to generate the detector threshold voltage, VTH, as will be described. In operation, the PDAC voltage varies in accordance with certain variations in the positive peak values of the V_{sig} voltage. The resolution of the PDAC 318 is selected to ensure that changes in the VTH threshold voltage caused by changes in the PDAC voltage are substantially imperceptible. In the illustrative embodiment, the resolution of the PDAC 318 is 50mV. The PDAC voltage is coupled to a buffer 324 and is fed back to the positive input of comparator 300, as shown.

The comparator 300, NOR gate 308, counter 314, PDAC 318 and buffer 324 comprise a "positive portion" of the detector circuitry. A "negative portion" of the detector is provided from comparator 304, NOR gate 312, counter 330, NDAC 334 and buffer 336. Specifically, the output of comparator 304 is coupled to the HOLD input of counter 330. The counter 330 is further responsive to the clock signal CLK and a reset signal provided from NOR gate 312.

The outputs of counter 330 are coupled to inputs of a Negative Digital-to-Analog Converter (NDAC) 334 which produces an NDAC voltage used, along with the PDAC voltage, to generate the VTH threshold voltage. The NDAC voltage varies in accordance with certain variations in the negative peak values of the V_{sig} voltage. Like the PDAC 318, the resolution of the NDAC 334 is selected to ensure that changes in the VTH threshold voltage caused by changes in the NDAC voltage are substantially imperceptible. In the illustrative embodiment, the resolution of the NDAC 334 is 50mV. The NDAC voltage is coupled to a buffer 336 and is further fed back to the negative input of comparator 304, as shown. Since the positive and negative portions of the detector circuitry provide signals PDAC, NDAC which track the positive and negative excursions of the signal voltage V_{sig}, these circuit portions may also be referred to as first and second tracking circuits respectively.

The buffered PDAC and NDAC voltages PDAC_BUF, NDAC_BUF are coupled to a resistor divider 340 comprising series resistors 342, 344, 346 and 348 in order to generate the VTH threshold voltage which is coupled to the negative input of threshold comparator 360 through resistor R3 for comparison to the V_{sig} voltage. Comparator 360 provides at an output thereof the detector output signal, Vₒᵤₜ, which is at a first binary, or logic level when the V_{sig} voltage exceeds the VTH threshold voltage and is at a second binary level when the V_{sig} voltage is less than the VTH threshold voltage.

The output of buffer 324 is also coupled to an input of a voltage generation circuit 370 which receives the buffered PDAC voltage PDAC_BUF and generates a signal voltage PDAC ΔV1, which is a predetermined voltage less than the PDAC_BUF voltage. Signal voltage PDAC ΔV1 is coupled to an input of a forcing circuit controller 306, the operation of which will be described in detail further below.

The VTH threshold voltage is set at a percentage of the peak-to-peak V_{sig} voltage and is adaptive in the sense that it is updated in accordance with certain variations in the V_{sig} voltage so as to remain the percentage, within a predetermined tolerance, of the peak-to-peak V_{sig} voltage. As will become apparent, this arrangement is achieved by using the PDAC and NDAC voltages to generate the VTH threshold voltage and varying the PDAC and NDAC voltages in accordance with certain variations in the positive and negative peak values of V_{sig}, respectively.

The VTH threshold voltage is provided with hysteresis in the sense that VTH is at a first level corresponding to a first percentage of the peak-to-peak V_{sig} voltage when V_{sig} exceeds the VTH threshold voltage and is at a second level corresponding to a second percentage of the peak-to-peak V_{sig} voltage when V_{sig} is less than the VTH threshold voltage. That is, once the V_{sig} voltage falls below the first level of the VTH threshold voltage, the VTH threshold voltage is increased so that the V_{sig} voltage has to exceed a second, higher level of the VTH threshold voltage before the Vₒᵤₜ signal transitions. In the illustrative embodiment, the first and second percentages are fixed percentages of the peak-to-peak V_{sig} voltage, but providing the percentages as variable percentages of the peak-to-peak V_{sig} voltage is within the scope of the invention.

More particularly, a pair of switches 366, 368 is provided for selectively "shorting" respective resistors 342, 348. To this end, switches 366 and 368 are coupled in parallel with resistors 342 and 348 of resistor divider 340, respectively. The Vₒᵤₜ signal from comparator 360 is inverted by an inverter 364 to provide a signal Vₒᵤₜₙₒₜ which is applied to a control input of switches 366 and 368, as shown. A second control input of switches 366 and 368 is responsive to the Vₒᵤₜ signal.

A forcing circuit 380 has a first input coupled to a node of resistor divider 340 through resistor R3 as shown and a first output coupled to a negative input of comparator 360. Forcing circuit 380 includes a first transistor switch 382 having a first terminal coupled to a reference voltage V_{reg}, a second terminal coupled through a resistor R1 to the negative input of comparator 360 as shown. A third or control terminal of transistor 382 received a control signal YANK_UPNOT from forcing circuit controller 306.

Forcing circuit 380 also includes a second transistor 384 having a first terminal coupled to a first reference voltage, here corresponding to ground, a second terminal coupled through a resistor R2 to the negative input of comparator 360 as shown and a third or control terminal coupled to a control signal YANK_DOWN from forcing circuit controller 306. In this particular embodiment, transistors 382, 384 are each provided as field effect transistors (FETs). In particular, transistor 382 is provided as a p-type metal oxide semiconductor field effect transistor (MOSFET) while transistor 384 is provided as an N-type MOSFET.

Forcing circuit controller 306 provides control signals YANK UPNOT, YANK_DOWN having predetermined voltage levels in response to input signals PDAC - ΔV1, NDAC_BUF, PNDAC_RES, Vₒᵤₜₙₒₜ and STARTUP fed thereto. When control signals YANK_UPNOT, YANK_DOWN are provided having respective ones of low and high logic levels, transistors 382, 384 are biased in their conduction states and conversely when signals YANK_UPNOT, YANK_DOWN are provided having respective ones of high and low logic levels, transistors 382, 384 are biased in their nonconduction states.

In operation, with forcing circuit 380 disabled (i.e. transistors 382, 384 each biased into their non-conduction states) resistor divider circuit 340 provides a threshold voltage VTH which is coupled through resistor R3 to the negative input terminal of comparator 360 for comparison to the V_{sig} voltage. In a preferred embodiment, resistor R3 is selected having a resistance value which is relatively high compared with the resistance value at the node of resistor divider circuit 340 to which resistor R3 is connected. Thus, there is relatively little voltage drop across R3. The output of comparator 360 provides the detector output signal, Vₒᵤₜ, which is at a first binary, or logic level when the V_{sig} voltage exceeds the threshold voltage VTH and is at a second binary level when the V_{sig} voltage is less than the threshold voltage VTH.

When forcing circuit 380 is enabled, however, one of transistors 382, 384 is biased into its respective conduction state thereby pulling or forcing the signal voltage on the negative input of comparator 360 to one of two predetermined values. This, in turn, forces the output signal Vₒᵤₜ to a predetermined one of its binary states. Thus with the forcing circuit 380 enabled, the output signal Vₒᵤₜ is forced to and maintained at a predetermined value for as long as the forcing circuit 380 remains enabled.

As discussed above in conjunction with Figure 33, operation of the proximity detector in peak-to-peak percentage threshold mode during initial proximity detector startup and during AGC operation requires the forcing circuit to be enabled in response to two conditions. Namely, the forcing circuit 380 is enabled during an initial startup interval and in response to every engagement of AGC. By forcing the signal Vₒᵤₜ to particular values in these two instances, the output signal voltage Vₒᵤₜ is forced to its correct binary state.

It should be noted that for operation at initial startup, circuit 380 need only include a single transistor since it is only necessary to force the signal voltage Vₒᵤₜ into either a high state or a low state. The two transistors of switch circuit 380, however, are required to support operation in AGC mode since in an AGC mode it may sometimes be necessary to force signal voltage Vₒᵤₜ high while other times it may be necessary to force signal voltage Vₒᵤₜ low.

It should also be noted that although forcing circuit 380 is here shown to include a pair of transistors, it should be appreciated that the function provided by forcing circuit 380 may be provided from a number of different circuits. For example, a current source may be used to turn the comparator 360 on and off. Alternately still, a combinatorial logic circuit may be coupled to the comparator output port to thus force the output voltage Vₒᵤₜ to a predetermined voltage level. Alternatively still, circuit 380 may include a mux or an operational amplifier rather than transistor switches to force the signal voltage Vₒᵤₜ into a predetermined state.

Referring now to Figure 35, the Hall element 10 has an output connected to the input of a Hall voltage amplifier 12 which includes a fixed-gain amplifier stage 65 a programmable-gain amplifier composed of a digital-to-analog converter G-DAC 67, an operational amplifier 69 and a resistor 73 coupled as shown. The operation of Hall voltage amplifier 12 is similar to that described above in conjunction with Figure 1.

An AGC reference generator 292 is coupled to AGC counter 290 which in turn is coupled to voltage amplifier 12. AGC reference generator 292 provides a clock signal to AGC counter 290. AGC counter 290 provides a signal to G-DAC 67 to adjust the gain of amplifier 12 such that the signal V_{sig} has a substantially constant peak-to-peak value regardless of the air gap to which the Hall element 10 is subject.

At initial startup, signal STARTUP is fed to a reset input of an RS latch 390 and a signal STARTUP_NOT is fed to reset inputs of a D flip-flop 396 and a counter 398 which are asserted low. Thus, in response to signals STARTUP and STARTUP_NOT, latch 390, flip-flop 396 and counter 398 each provide predetermined output signals at output ports thereof. This results in amplifier 12 being set at a predetermined gain state.

Similarly, the startup signal STARTUP is fed to reset inputs of a one shot circuit 416 and an RS latch 418 in AGC reference generator 292. The outputs of one shot circuit 416 and RS latch 418 are coupled to the inputs of an AND logic gate 420 which provides the signal PNDAC_RES to an input of force controller circuit 306 (Figure 34).

AGC reference generator 292 includes a pair of comparators 406a, 406b which receive the output signal V_{sig} at respective ones of positive and negative ports as shown. The second input ports of comparators 406a, 406b are coupled to a resistor divider which generates signals HIGHREF and LOWREF at the second input ports of comparators 406a, 406b.

During AGC mode, comparator circuits 406a, 406b in AGC reference generator 292 provide signals TOO_BIG and TOO_SMALL in response to the signal voltage V_{sig} being either greater than a reference voltage HIGHREF or lower than reference voltage LOWREF respectively. In response to the signal voltage V_{sig} having a value such that AGC is activated, the signals TOO_BIG, TOO_SMALL are coupled through NOR gates 412, 414 to one shot 416.

In response to the signal V_{sig} having a voltage level which is greater than the voltage level of HIGH REF, comparator 406a provides a logic high signal to an input of NOR gate 412. NOR gate 412 thus provides a logic low input to NOR gate 414 and if the count 128 signal has not yet been reached then the AGC is enabled. A one shot circuit 416 controls the duration of the forcing circuit control signal pulse (i.e. the yank pulse) in AGC mode by providing an appropriate signal to the input of AND gate 420.

Referring now to Figure 36, a forcing control circuit 306 which implements logic to appropriately enable and disable the forcing circuit 380 to carry out the operations described above in conjunction with Figures 33 and 34.is shown. It should be noted that although a particular set of logic gates is here shown, those of ordinary skill in the art will appreciate that other logic gates or circuits may be used to implement the same or similar logic functions suitable for the intended purpose of determining whether and when the comparator output voltage Vₒᵤₜ is forced high or low.

Forcing circuit controller 306 receives input signals and in response thereto determines when and in what direction to bias the negative input of comparator 360. Determining whether the comparator input is forced high or low also determines the signal level of output signal Vₒᵤₜ. In this particular embodiment, forcing circuit controller 306 provides control signals YANK_UPNOT, YANK_DOWN to gate terminals of switches 382, 384, to thus bias the switches into conduction or non-conduction states and thereby coupling the negative input of comparator 360 (Figure 34) to a reference voltage close to one of the rail voltages thereby determining the signal level of output signal Vₒᵤₜ.

At startup, the signal CNT3_DISABLE has a logic low signal level and the signal STARTUP is provided having a logic high signal level. Thus the output of NOR gate 436 is a logic zero and the input to NAND gate 432 is also a logic one.

The value PDAC-ΔV1 is initially set to a low value and the value NDAC_BUF is set to a value close to the positive rail voltage and thus comparator 426 provides a logic one at the output thereof. This results in NOR gate 428 providing a logic zero at an output thereof. The signal CNT3_DISABLE is also a logic zero and thus NOR gate 430 provides a logic one to an input of NAND gate 432. Thus NAND gate 432 provides a signal YANK_UPNOT having a value of logic zero which biases transistor 382 into its conduction state thereby forcing the output signal Vₒᵤₜ to a predetermined value which in this case is a logic low value. It should be appreciated that output signal Vₒᵤₜ could alternatively have been forced to a high logic value. The particular value to which Vₒᵤₜ is forced may be selected to satisfy the requirements of a particular application.

In AGC operation, comparator 426 receives the signal PDAC - ΔV1 on a negative input port thereof and signal NDAC_BUF on a positive input port thereof. The output of comparator 426 switches when the value of PDAC - ΔV1 exceeds the value of NDAC_BUF. Thus, comparator 426 does not allow the forcing circuit to release the output signal voltage Vₒᵤₜ until the signals PDAC_BUF and NDAC_BUF are separated by a predetermined voltage level. The predetermined voltage level ΔV1 is selected to assure that false switching will not occur. In this particular application, the predetermined voltage is selected to be 150 milli-volts (mv).

Referring now to Figure 37, a plot of signal amplitude versus time is shown. In the plot, it can be seen that at time zero, initial power occurs and the value of PDAC is set to a value which is lower than the least positive expected value of the signal voltage V_{sig} and the value of NDAC is set to a value which is greater than the least negative expected value of signal voltage V_{sig}. In this particular embodiment, the supply voltage is three volts and the reset value for the signal PDAC is about .57 volt while the reset value for the signal NDAC is about 2.43 volts. Since the value of PDAC is less than the value of NDAC, the forcing or yank function is enabled.

After a brief reset period, the value of PDAC increases until reaching the value of V_{sig} and the value of NDAC decreases until reaching the value of V_{sig}. At time A, the value of PDAC is slightly greater than the value of NDAC. At time A, however, the value of PDAC is not greater than the value of NDAC by an amount ΔV1 required to allow the forcing circuit to be disabled. In this particular embodiment, the value of PDAC must be greater than the value of NDAC by three bits which equals a voltage of 150 millivolts. Thus, at time A the forcing circuit is still enabled.

It is necessary to force the comparator input to a predetermined level to keep the comparator from oscillating in this circuit implementation, as well as to maintain the comparator's previous state. When PDAC is less than NDAC, switches 366 and 368 cause positive hysteresis with the threshold comparator 360 (Figure 34). The forcing circuit breaks the positive feedback loop by biasing the comparator's input to hold the comparator in its present state.

The signal voltage VTH is coupled to the negative input of threshold comparator 360 (Figure 34). The negative input of comparator 360 is also the input which is forced to one of high and low reference voltages as shown in Figure 37. Until the value of PDAC exceeds the value of NDAC by a voltage level not less than the predetermined voltage level, the switch 382 is biased into its conduction state thus forcing the signal voltage VTH toward a voltage close to the positive rail voltage. This has the effect of keeping the output signal voltage Vₒᵤₜ low. Although in this particular example the output signal voltage Vₒᵤₜ is selected to be in a low state at initial startup, in some applications it may be desirable to force the output signal voltage Vₒᵤₜ into a high state at initial startup.

Once the peak-to-peak signal is greater than the predetermined voltage ΔV1, the forcing circuit is disabled and the signal voltage VTH is 35% of the difference between the signals PDAC_BUF and NDAC_BUF. The threshold comparator 360 switches at time B since the signal voltage V_{sig} is greater than the threshold voltage VTH by more than the predetermined threshold voltage.

The amplitude of signal voltage V_{sig} continues to increase until it reaches the HIGHREF threshold and thus triggering the first AGC cycle during time period T_{AGC}. Since the comparator output is high when AGC is engaged, the transistor 382 is biased into its non-conduction state and transistor 384 is biased into its conduction state to hold the comparator in its present state. In Figure 37 the signal voltage VTH is forced to a voltage close to the negative rail voltage and held until the value of PDAC (or PDAC_BUF) is greater than the value of NDAC (or NDAC_BUF) by the predetermined voltage level which in this particular example is equal to 150 mV.

Yank down remains enabled until time C because the difference between PDAC and NDAC is less than the predetermined voltage of 150mV. PDAC is reset to its minimum reset value and NDAC to its maximum reset value, and then PDAC and NDAC are again allowed to track the signal V_{sig}. Four cycles of AGC occur, as can be clearly seen in Figure 37 by PDAC resetting down at times T₁, T₂, T₃, T₄. After time T₄, the signal V_{sig} reaches the positive peak and PDAC, NDAC again start to track the signal V_{sig}. Once NDAC reaches a value such that the value of NDAC is less than the value of PDAC by a predetermined voltage, the forcing circuit is disabled as shown at time C. This allows the comparator to switch normally, and since the signal voltage VTH is now greater than the signal V_{sig}, the comparator output switches low (time C).

## Claims

1. A proximity detector for sensing magnetic articles comprising:
a) a magnetic-field-to-voltage transducer (10,252) for generating at an output port thereof a signal voltage, V_{sig}, that is proportional to a magnetic field; and
b) a threshold detector having an input port coupled to the output port of said magnetic-field-to-voltage transducer to receive the signal voltage V_{sig} and for providing an output signal voltage Vₒᵤₜ;
**characterized in that** the threshold detector is a peak-to-peak percentage threshold detector, and the proximity detector further comprises
c) a forcing circuit (270,380) coupled to said peak-to-peak percentage threshold detector for maintaining the value of the output signal voltage Vₒᵤₜ at a first predetermined value at least until a voltage change in the signal voltage V_{sig} which is greater than a predetermined voltage is detected.

2. The proximity detector of Claim 1 wherein:
said peak-to-peak percentage threshold detector further comprises a threshold comparator (268a,268b,360) having a first input terminal coupled to the output port of said magnetic-field-to-voltage transducer to receive the signal voltage, V_{sig}, and having a second input terminal coupled to receive a threshold signal voltage VTH.

3. The proximity detector of Claim 2 wherein the predetermined voltage is not less than an internal hysteresis voltage of said threshold comparator.

4. The proximity detector of Claim 1 wherein said peak-to-peak percentage threshold detector further comprises:
a first tracking circuit (260a,262a,264a) having input coupled to the output of said magnetic-field-to-voltage transducer to receive the signal voltage, V_{sig}, and to generate at an output thereof a signal voltage PDAC that tracks the highest peak of the signal voltage V_{sig};
a second tracking circuit (260b,262b,264b) having input coupled to the output of said magnetic-field-to voltage transducer to receive the signal voltage, V_{sig}, and to generate at an output thereof a voltage NDAC that tracks the lowest peak of the signal voltage V_{sig}; and
a circuit (262a,262b) for setting an initial starting voltage of the signal voltage PDAC to a value which is less than an initial starting voltage of the signal voltage NDAC.

5. The proximity detector of Claim 2 wherein:
(a) said peak-to-peak percentage threshold detector further comprises:
a first tracking circuit (300,314,318) having an input coupled to the output of said magnetic-field-to-voltage transducer to receive the signal voltage, V_{sig}, and to generate at an output thereof a signal voltage PDAC that tracks the highest peak of the signal voltage V_{sig};
a second tracking circuit (304,330,334) having an input coupled to the output of said magnetic-field-to-voltage transducer to receive the signal voltage, V_{sig}, and to generate at an output thereof a voltage NDAC, that tracks the lowest peak of the signal voltage V_{sig}; and
a resistor divider (340) having a first terminal coupled to the output port of said first tracking circuit, having a second terminal coupled to the output port of said second tracking circuit and having a third terminal coupled to the second input terminal of said threshold detector, said resistor divider for providing the threshold signal voltage VTH at the third terminal thereof; and
(b) said forcing circuit (380) is coupled to the second input terminal of said threshold comparator.

6. The proximity detector of Claim 5 wherein said forcing circuit comprises a switch circuit (382,384) having a first terminal coupled to the second input terminal of said threshold comparator, a second terminal coupled to a first reference voltage and a control terminal coupled to receive a control signal and in response to the control signal having a first value said switch circuit provides a first voltage level to the second input terminal of said threshold comparator and in response to the control signal having a second value said switch circuit provides a second different voltage level to the second input terminal of said threshold comparator.

7. The proximity detector of Claim 6 wherein said switch circuit further comprises:
a first transistor (382) having a first terminal coupled to the second input terminal of said threshold comparator, a second terminal coupled to a first reference voltage and a control terminal;
a second transistor (384) having a first terminal coupled to the second input terminal of said threshold comparator, a second terminal coupled to a second reference voltage and a control terminal; and
a logic circuit (306) for receiving a startup signal and for providing predetermined control signals to the control terminals of said first and second transistors in response to the startup signal having a predetermined value.

8. The proximity detector of Claim 7 wherein:
said first transistor (382) is a field effect transistor having source, drain and gate electrodes and wherein the first terminal corresponds to the drain electrode, the second terminal corresponds to the source electrode and the control terminal corresponds to the gate electrode;
said second transistor (384) is a field effect transistor having source, drain and gate electrodes wherein the first terminal corresponds to the drain electrode, the second terminal corresponds to the source electrode and the control terminal corresponds to the gate electrode;
said first reference voltage corresponds to a positive reference voltage; and
said second reference voltage corresponds to ground.

9. The proximity detector of Claim 8 wherein:
(a) said first tracking circuit comprises:
(1) a first comparator (300) having a first input port coupled to the output port of said magnetic-field-to-voltage transducer, having a second input port and having an output port;
(2) a second counter (314) having a first input port coupled to the output port of said first comparator, a clock port for receiving a clock signal, a startup port for receiving a startup signal and an output port; and
(3) a first digital-to-analog converter (318) having an input port coupled to the output port of said second counter and having an output port coupled to the second input port of said first comparator (300) and corresponding to the output port of said first tracking circuit; and
(b) said second tracking circuit comprises:
(1) a second comparator (304) having a first input port coupled to the output port of said magnetic-field-to-voltage transducer, having a second input port and having an output port;
(2) a first counter (330) having a first input port coupled to the output port of said second comparator, a clock port for receiving a clock signal, a startup port for receiving a startup signal and an output port; and
(3) a second digital-to-analog converter (334) having an input port coupled to the output port of said first counter and having an output port coupled to the second input port of said second comparator (304) and corresponding to the output port of said second tracking circuit.

10. A method associated with a proximity detector including a magnetic-field-to-voltage transducer (10,252) which provides a signal voltage, V_{sig} to a threshold detector which includes a threshold comparator (268a,268b,360) and which generates an output signal voltage Vₒᵤₜ, **characterized in that** the threshold detector is a peak-to-peak percentage threshold detector which includes first and second tracking circuits, and the method comprises the steps of:
(a) setting an output value of the first tracking circuit to a value which is lower than the least positive expected value of the signal voltage V_{sig} wherein the first tracking circuit receives the signal voltage V_{sig}, and generates at an output port thereof a voltage PDAC, that tracks the highest peak of the signal voltage V_{sig};
(b) setting an output value of the second tracking circuit to a value which is greater than the least negative expected value of the signal voltage V_{sig} wherein the second tracking circuit receives the signal voltage V_{sig}, and generates at an output port thereof a signal voltage NDAC, that tracks the lowest peak of the signal voltage V_{sig}; and
(c) maintaining the output signal voltage Vₒᵤₜ at a first predetermined value by applying a reference voltage to an input terminal of the threshold comparator, wherein the value of the output signal voltage Vₒᵤₜ is maintained at least until the peak-to-peak percentage threshold detector detects a change in the signal voltage V_{sig} which is greater than a predetermined voltage.

11. The method of Claim 10 further comprising the steps of:
(d) sensing an ambient magnetic field and generating the voltage, Vsig, that is proportional to the magnetic field; and
(e) in response to detection of a voltage change in the signal voltage V_{sig} which is greater than the predetermined voltage, removing the reference voltage from the input terminal of the threshold comparator.

12. The method of Claim 11 wherein the step of maintaining the output signal voltage Vₒᵤₜ at a first predetermined value by applying a reference voltage to an input terminal of the threshold comparator (360) comprises the steps of:
biasing a first transistor (382) coupled between a reference voltage and the input terminal of the threshold comparator into a first one of a conduction state and a non-conduction state.

13. The method of Claim 12 wherein the step of removing the reference voltage from the input terminal of the threshold comparator includes the step of:
biasing the first transistor (382) into a second one of the conduction and non-conduction states.

14. The proximity detector of claim 1 further comprising:
an automatic gain control circuit (12) having an input port coupled to the output port of said magnetic-field-to-voltage transducer (10) and having an output port coupled to the input port of the peak-to-peak percentage threshold detector, wherein said forcing circuit is further coupled to said automatic gain control circuit for maintaining the value of the output signal voltage Vₒᵤₜ at a first predetermined value to prevent said peak-to-peak percentage threshold detector from switching prior to one of a positive or negative excursion of the signal voltage V_{sig} reaching a predetermined threshold voltage when said automatic gain control circuit controls.the amplitude of the signal voltage V_{sig}.

15. The proximity detector of Claim 14 wherein:
said peak-to-peak percentage threshold detector further comprises:
a first tracking circuit (300,314,318) having an input port coupled to the output port of said magnetic-field-to-voltage transducer to receive the signal voltage, V_{sig}, and to generate at an output port thereof a signal voltage PDAC, that tracks the highest peak of the signal voltage V_{sig};
a second tracking circuit (304,330,334) having an input port coupled to the output port of said magnetic-field-to-voltage transducer to receive the signal voltage, V_{sig}, and to generate at an output port thereof a voltage NDAC, that tracks the lowest peak of the signal voltage V_{sig}; and
a threshold comparator (360) having a first input terminal coupled to the output port of said automatic gain control circuit (12) to receive the signal voltage, V_{sig}, and having a second input terminal coupled to the receive a threshold voltage VTH;
said automatic gain control circuit comprises:
a logic circuit (292) coupled to said first and second tracking circuits, said logic circuit to generate a reset signal to reset the voltage PDAC of said first tracking circuit to a value which is lower than the least positive expected value of the signal voltage V_{sig} and to reset the voltage NDAC of said second tracking circuit to a value which is greater than the least negative expected value of the signal voltage V_{sig;}
and
said forcing circuit (380) maintains the value of the output signal voltage Vₒᵤₜ at a first predetermined value at least until the peak-to-peak percentage threshold detector detects a voltage change in the signal voltage V_{sig} which is greater than a predetermined voltage.

16. The proximity detector of Claim 15 wherein:
said peak-to-peak percentage threshold detector further comprises:
a resistor divider (340) having a first terminal coupled to the output port of said first tracking circuit, having a second terminal coupled to the output port of said second tracking circuit and having a third terminal coupled to the second input terminal of said threshold detector, said resistor divider for providing the threshold voltage VTH at the third terminal thereof; and
said forcing circuit (380) is coupled to the second input terminal of said threshold comparator (360).

17. The proximity detector of Claim 16 wherein said forcing circuit (380) comprises a switch circuit (382,384) having a first terminal coupled to the second input terminal of said threshold comparator (360), a second terminal coupled to a first reference voltage and a control terminal coupled to receive a control signal wherein in response to the control signal having a first value said switch circuit provides a first voltage level to the second input terminal of said threshold comparator and in response to the control signal having a second value said switch circuit provides a second different voltage level to the second input terminal of said threshold comparator.

18. The proximity detector of Claim 17 wherein said switch circuit further comprises:
a first transistor (382) having a first terminal coupled to the second input terminal of said threshold comparator, a second terminal coupled to a first reference voltage and a control terminal;
a second transistor (384) having a first terminal coupled to the second input terminal of said threshold comparator, a second terminal coupled to a second reference voltage and a control terminal; and
a logic circuit (306) for receiving one of a startup signal and a reset signal and for providing predetermined control signals to the control terminals of said first and second transistors in response to the one of the startup signal and reset signal.

19. The proximity detector of Claim 18 wherein:
said first transistor (382) is a field effect transistor having a source electrode corresponding to the first terminal, a drain electrode corresponding to the second terminal and a gate electrode corresponding to the third terminal;
said second transistor (384) is a field effect transistor having a source electrode corresponding to the first terminal, a drain electrode corresponding to the second terminal and a gate electrode corresponding to the third terminal;
said first reference voltage corresponds to a positive reference voltage; and
said second reference voltage corresponds to ground.

20. The proximity detector of Claim 19 wherein:
(a) said first tracking circuit comprises:
(1) a first comparator (300) having a first input port coupled to the output port of said magnetic-field-to-voltage transducer, having a second input port and having an output port;
(2) a first counter (314) having a first input port coupled to the output port of said first comparator, a clock port for receiving a clock signal, a startup port for receiving a startup signal and an output port; and
(3) a first digital-to-analog converter (318) having an input port coupled to the output port of said first counter and having an output port coupled to the second input port of said first comparator (300) and corresponding to the output port of said first tracking circuit; and
(b) said second tracking circuit comprises:
(1) a second comparator (304) having a first input port coupled to the output port of said magnetic-field-to-voltage transducer, having a second input port and having an output port;
(2) a second counter (330) having a first input port coupled to the output port of said second comparator, a clock port for receiving a clock signal, a startup port for receiving a startup signal and an output port; and
(3) a second digital-to-analog converter (334) having an input port coupled to the output port of said second counter and having an output port coupled to the second input port of said second comparator (304) and corresponding to the output port of said second tracking circuit.

21. The method of Claim 10 further comprising the steps of:
(d) resetting the voltage PDAC of said first tracking circuit to a value which is lower than the least positive expected value of the signal voltage V_{sig} in response to an automatic gain control enable pulse; and
(e) resetting the voltage NDAC of said second tracking circuit to a value which is greater than the least negative expected value of the signal voltage V_{sig} in response to the automatic gain control enable pulse.

## Patentansprüche

1. Nährungsdetektor zum Erfassen magnetischer Gegenstände, der umfasst:
a) einen Manetfeld-Spannungs-Wandler (10, 252), der an einem Ausgangsanschluss desselben eine Signalspannung V_{sig} erzeugt, die proportional zu einem Magnetfeld ist; und
b) einen Schwellenwert-Detektor, der einen Eingangsanschluss hat, der mit dem Ausgangsanschluss des Magnetfeld-Spannungs-Wandlers verbunden ist, um die Signalspannung V_{sig} zu empfangen und eine Ausgangs-Signalspannung Vₒᵤₜ bereitzustellen;
**dadurch gekennzeichnet, dass** der Schwellenwert-Detektor ein Spitze-Spitze-Verhältnis-Schwellenwertdetektor ist und der Näherungsdetektor des Weiteren umfasst:
c) eine Eingreifschaltung (270, 380), die mit dem Spitze-Spitze-Verhältnis-Schwellenwertdetektor verbunden ist, um den Wert der Ausgangs-Signalspannung Vₒᵤₜ wenigstens solange auf einem ersten vorgegebenen Wert zu halten, bis eine Spannungsänderung der Signalspannung V_{sig} erfasst wird, die größer ist als eine vorgegebene Spannung.

2. Näherungsdetektor nach Anspruch 1, wobei:
der Spitze-Spitze-Verhältnis-Schwellenwertdetektor des Weiteren einen Schwellenvergleicher (268a, 268b, 360) umfasst, der einen ersten Eingangs-Anschlusspunkt hat, der mit dem Ausgangsanschluss des Magnetfeld-Spannungs-Wandlers verbunden ist, um die Signalspannung V_{sig} zu empfangen, und einen zweiten Eingangs-Anschlusspunkt hat, der so geschaltet ist, dass er eine Schwellenwert-Signalspannung VTH empfängt.

3. Näherungsdetektor nach Anspruch 2, wobei die vorgegebene Spannung nicht geringer ist als eine interne Hysteresespannung des Schwellenwertvergleichers.

4. Näherungsdetektor nach Anspruch 1, wobei der Spitze-Spitze-Verhältnis-Schwellenwertdetektor des Weiteren umfasst:
eine erste Nachlaufschaltung (260a, 262a, 264a), die einen Eingang hat, der mit dem Ausgang des Magnetfeld-Spannungs-Wandlers verbunden ist, um die Signalspannung V_{sig} zu empfangen und an einem Ausgang derselben eine Signalspannung PDAC zu erzeugen, die der höchsten Spitze der Signalspannung V_{sig} nachläuft;
eine zweite Nachlaufschaltung (260b, 262b, 264b), die einen Eingang hat, der mit dem Ausgang des Magnetfeld-Spannungs-Wandlers verbunden ist, um die Signalspannung V_{sig} zu empfangen und an einem Ausgang derselben eine Spannung NDAC zu erzeugen, die der niedrigsten Spitze der Signalspannung V_{sig} nachläuft; und
eine Schaltung (262a, 262b) zum Einstellen einer Ausgangs-Anfangsspannung der Signalspannung PDAC auf einen Wert, der geringer ist als eine Ausgangs-Anfangsspannung der Signalspannung NDAC.

5. Nährungsdetektor nach Anspruch 2, wobei:
(a) der Spitze-Spitze-Verhältnis-Schwellenwertdetektor des Weiteren umfasst:
eine erste Nachlaufschaltung (300, 314, 318), die einen Eingang hat, der mit dem Ausgang des Magnetfeld-Spannungs-Wandlers verbunden ist, um die Signalspannung V_{sig} zu empfangen, und an einem Ausgang derselben einer Signalspannung PDAC zu erzeugen, die der höchsten Spitze der Signalspannung V_{sig} nachläuft;
eine zweite Nachlaufschaltung (304, 330, 334), die einen Eingang hat, der mit dem Ausgang des Magnetfeld-Spannungs-Wandlers gekoppelt ist, um die Signalspannung V_{sig} zu empfangen und an einem Ausgang derselben eine Spannung NDAC zu erzeugen, die der niedrigsten Spitze der Signalspannung V_{sig} folgt; und
einen Widerstands-Teiler (340), der einen ersten Anschlusspunkt hat, der mit dem Ausgangsanschluss der ersten Nachlaufschaltung verbunden ist, einen zweiten Anschlusspunkt hat, der mit dem Ausgangsanschluss der zweiten Nachlaufschaltung verbunden ist, und einen dritten Anschlusspunkt hat, der mit dem zweiten Eingangsanschluss des Schwellenwertdetektors verbunden ist, wobei der Widerstands-Teiler dazu dient, die Schwellenwert-Signalspannung VTH am dritten Anschlusspunkt desselben bereitzustellen; und
(b) die Eingriffsschaltung (380) mit dem zweiten Eingangs-Anschlusspunkt des Schwellenwertvergleichers verbunden ist.

6. Nährungsdetektor nach Anspruch 5, wobei die Eingriffsschaltung einen Schaltkreis (382, 384) umfasst, der einen ersten Anschlusspunkt, der mit dem zweiten Eingangs-Anschlusspunkt des Schwellenwertvergleichers verbunden ist, einen zweiten Anschlusspunkt, der mit einer ersten Bezugsspannung verbunden ist, und einen Steuer-Anschlusspunkt hat, der so geschaltet ist, dass er ein Steuersignal empfängt, und wobei der Schaltkreis in Reaktion darauf, dass das Steuersignal einen ersten Wert hat, dem zweiten Eingangs-Anschlusspunkt des Schwellenwertvergleichers einen ersten Spannungspegel bereitstellt und der Schaltkreis in Reaktion darauf, dass das Steuersignal einen zweiten Wert hat, dem zweiten Eingangs-Anschlusspunkt des Schwellenwertvergleichers einen zweiten, anderen Spannungspegel bereitstellt.

7. Näherungsdetektor nach Anspruch 6, wobei der Schaltkreis des Weiteren umfasst:
einen ersten Transistor (382), der einen ersten Anschlusspunkt, der mit dem zweiten Eingangs-Anschlusspunkt des Schwellenwertvergleichers verbunden ist, einen zweiten Anschlusspunkt, der mit einer ersten Bezugsspannung verbunden ist, und einen Steuer-Anschlusspunkt hat;
einen zweiten Transistor (384), der einen ersten Anschlusspunkt, der mit dem zweiten Eingangs-Anschluss des Schwellenwertvergleichers verbunden ist, einen zweiten Anschlusspunkt, der mit einer zweiten Bezugsspannung verbunden ist, und einen Steuer-Anschlusspunkt hat; und
eine Logikschaltung (306), die ein Anlaufsignal empfängt und den Steuer-Anschlusspunkten des ersten und des zweiten Transistors in Reaktion darauf, dass das Anlaufsignal einen vorgegebenen Wert hat, vorgegebene Steuersignale bereitstellt.

8. Näherungsdetektor nach Anspruch 7, wobei:
der erste Transistor (382) ein Feldeffekttransistor mit Source-, Drain- und Gate-Elektrode ist, und wobei der erste Anschlusspunkt der Drain-Elektrode entspricht, der zweite Anschlusspunkt der Source-Elektrode entspricht und der Steuer-Anschlusspunkt der Gate-Elektrode entspricht;
der zweite Transistor (384) ein Feldeffekttransistor mit Source-, Drain- und Gate-Elektrode ist, wobei der erste Anschlusspunkt der Drain-Elektrode entspricht, der zweite Anschlusspunkt der Source-Elektrode entspricht und der Steuer-Anschlusspunkt der Gate-Elektrode entspricht;
die erste Bezugsspannung einer positiven Bezugsspannung entspricht, und
die zweite Bezugsspannung Erde entspricht.

9. Näherungsdetektor nach Anspruch 8, wobei:
(a) die erste Nachlaufschaltung umfasst:
(1) einen ersten Vergleicher (300), der einen ersten Eingangsanschluss hat, der mit dem Ausgangsanschluss des Magnetfeld-Spannungs-Wandlers verbunden ist, einen zweiten Eingangsanschluss hat und einen Ausgangsanschluss hat;
(2) einen zweiten Zähler (314), der einen ersten Eingangsanschluss, der mit dem Ausgangsanschluss des ersten Vergleichers verbunden ist, einen Taktanschluss zum Empfangen eines Taktsignals, einen Anlauf-Anschluss zum Empfangen eines Anlaufsignals und einen Ausgangsanschluss hat; und
(3) einen ersten Digital-Analog-Wandler (318), der einen Eingangsanschluss hat, der mit dem Ausgangsanschluss des zweiten Zählers verbunden ist, und einen Ausgangsanschluss hat, der mit dem zweiten Eingangsanschluss des ersten Vergleichers (300) verbunden ist und dem Ausgangsanschluss der ersten Nachlaufschaltung entspricht; und
(b) die zweite Nachlaufschaltung umfasst:
(1) einen zweiten Vergleicher (304), der einen ersten Eingangsanschluss hat, der mit dem Ausgangsanschluss des Magnetfeld-Spannungs-Wandlers verbunden ist, einen zweiten Eingangsanschluss hat und einen Ausgangsanschluss hat;
(2) einen ersten Zähler (330), der einen ersten Eingangsanschluss, der mit dem Ausgangsanschluss des zweiten Vergleichers verbunden ist, einen Taktanschluss zum Empfangen eines Taktsignals, einen Anlauf-Anschluss zum Empfangen eines Anlaufsignals und einen Ausgangsanschluss hat; und
(3) einen zweiten Digital-Analog-Wandler (334), der einen Eingangsanschluss hat, der mit dem Ausgangsanschluss des ersten Zählers verbunden ist, und einen Ausgangsanschluss hat, der mit dem zweiten Eingangsanschluss des zweiten Vergleichers (304) verbunden ist und dem Ausgangsanschluss der zweiten Nachlaufschaltung entspricht.

10. Verfahren, das mit einem Näherungssensor zusammenhängt, der einen Magnetfeld-Spannungs-Wandler (10, 252) enthält, der einem Schwellenwertdetektor, der einem Schwellenwert-Vergleicher (268a, 268b, 360) enthält und der eine Ausgangs-Signalsspannung Vₒᵤₜ erzeugt, eine Signalspannung V_{sig} bereitstellt, **dadurch gekennzeichnet, dass** der Schwellenwertdetektor ein Spitze-Spitze-Verhältnis-Schwellenwertdetektor ist, der eine erste und eine zweite Nachlaufschaltung enthält, und wobei das Verfahren die folgenden Schritte umfasst:
(a) Einstellen eines Ausgangswertes der ersten Nachlaufschaltung auf einen Wert, der niedriger ist als der kleinste erwartete positive Wert der Signalspannung V_{sig}, wobei die erste Nachlaufschaltung die Signalspannung V_{sig} empfängt und an einem Ausgangsanschluss derselben eine Spannung PDAC erzeugt, die der höchsten Spitze der Signalspannung V_{sig} nachläuft;
(b) Einstellen eines Ausgangswertes der zweiten Nachlaufschaltung auf einen Wert, der größer ist als der kleinste erwarte negative Wert der Signalspannung V_{sig}, wobei die zweite Nachlaufschaltung die Signalspannung V_{sig} empfängt und an einem Ausgangsanschluss derselben eine Signalspannung NDAC erzeugt, die der niedrigsten Spitze der Signalspannung V_{sig} nachläuft; und
(c) Halten der Ausgangs-Signalspannung Vₒᵤₜ auf einem ersten vorgegebenen Wert, indem eine Bezugsspannung an einen Eingangs-Anschlusspunkt des Schwellenwertvergleichers angelegt wird, wobei der Wert der Ausgangs-Signalspannung Vₒᵤₜ wenigstens so lange aufrechterhalten wird, bis der Spitze-Spitze-Verhältnis-Schwellenwertdetektor eine Änderung der Signalspannung V_{sig} erfasst, die größer ist eine vorgegebene Spannung.

11. Verfahren nach Anspruch 10, das des Weiteren die folgenden Schritte umfasst:
(d) Messen eines umgebenden Magnetfeldes und Erzeugen der Spannung V_{sig}, die proportional zu dem Magnetfeld ist; und
(e) in Reaktion auf das Erfassen einer Spannungsänderung in der Signalspannung V_{sig}, die größer ist als die vorgegebene Spannung, Entfemen der Bezugsspannung von dem Eingangs-Anschlusspunkt des Schwellenwertvergleichers.

12. Verfahren nach Anspruch 11, wobei der Schritt des Haltens der Ausgangs-Signalspannung Vₒᵤₜ auf einem ersten vorgegebenen Wert durch Anlegen einer Bezugsspannung an einen Eingangs-Anschlusspunkt des Schwellenwertvergleichers (360) den folgenden Schritt umfasst:
Vorspannen eines ersten Transistors (382), der zwischen eine Bezugsspannung und den Eingangs-Anschlusspunkt des Schwellenwertvergleichers geschaltet ist, in einen ersten, d.h. einen leitenden oder einen nicht-leitenden, Zustand.

13. Verfahren nach Anspruch 12, wobei der Schritt des Entfernens der Bezugsspannung von dem Eingangs-Anschlusspunkt des Schwellenwertvergleichers den folgenden Schritt einschließt:
Vorspannen des Transistors (382) in einen zweiten, d.h. den leitenden oder den nicht-leitenden, Zustand.

14. Näherungsdetektor nach Anspruch 1, der des Weiteren umfasst:
eine Schaltung (12) zur automatischen Verstärkungsregelung, die einen Eingangsanschluss hat, der mit dem Ausgangsanschluss des Magnetfeld-Spannung-Wandlers (10) verbunden ist, und einen Ausgangsanschluss hat, der mit dem Eingangsanschluss des Spitze-Spitze-Verhältnis-Schwellenwertdetektors verbunden ist, wobei die Eingriffsschaltung des Weiteren mit der Schaltung zur automatischen Verstärkungsregelung verbunden ist, um den Wert der Ausgangs-Signalspannung Vₒᵤₜ auf einem ersten vorgegebenen Wert zu halten und zu verhindern, dass der Spitze-Spitze-Verhältnis-Schwellenwertdetektor schaltet, bevor ein positiver oder ein negativer Ausschlag der Signalspannung V_{sig} eine vorgegebene Schwellenwertspannung erreicht, wenn die Schaltung zur automatischen Verstärkungsregelung die Amplitude der Signalspannung V_{sig} regelt.

15. Näherungsdetektor nach Anspruch 14, wobei:
der Spitze-Spitze-Verhältnis-Schwellenwertdetektor des Weiteren umfasst:
eine erste Nachlaufschaltung (300, 314, 318), die einen Eingangsanschluss hat, der mit dem Ausgangsanschluss des Magnetfeld-Spannungs-Wandlers verbunden ist, um die Signalspannung V_{sig} zu empfangen und an einem Ausgangsanschluss derselben eine Signalspannung PDAC zu erzeugen, die der höchsten Spitze der Signalspannung V_{sig} nachläuft;
eine zweite Nachlaufschaltung (304, 330, 334), die einen Eingangsanschluss hat, der mit dem Ausgangsanschluss des Magnetfeld-Spannungs-Wandlers verbunden ist, um die Signalspannung V_{sig} zu empfangen und an einem Ausgangsanschluss derselben eine Spannung NDAC zu erzeugen, die der niedrigsten Spitze der Signalspannung V_{sig} nachläuft; und
einen Schwellenwertvergleicher (360), der einen ersten Eingangs-Anschlusspunkt hat, der mit dem Ausgangsanschluss der Schaltung (12) zur automatischen Verstärkungsregelung verbunden ist, um die Signalspannung V_{sig} zu empfangen, und einen zweiten Eingangs-Anschlusspunkt hat, der so geschaltet ist, dass er eine Schwellenwertspannung VTH empfängt;
die Schaltung zur automatischen Verstärkungsregelung umfasst:
eine Logikschaltung (292), die mit der ersten und der zweiten Nachlaufschaltung verbunden ist, wobei die Logikschaltung ein Rücksetzsignal zum Zurücksetzen der Spannung PDAC der ersten Nachlaufschaltung auf einen Wert, der niedriger ist als der geringste erwartete positive Wert der Signalspannung V_{sig} und zum Zurücksetzen der Spannung NDAC der zweiten Nachlaufschaltung auf einen Wert, der größer ist als der geringste erwartete negative Wert der Signalspannung V_{sig}, erzeugt;
und
die Eingriffschaltung (380) den Wert der Ausgangs-Signalspannung Vₒᵤₜ wenigstens so lange auf einem ersten vorgegebenen Wert hält, bis der Spitze-Spitze-Verhältnis-Schwellenwertdetektor eine Spannungsänderung in der Signalspannung V_{sig} erfasst, die größer ist als eine vorgegebene Spannung.

16. Näherungsdetektor nach Anspruch 15, wobei:
der Spitze-Spitze-Verhältnis-Schwellenwertdetektor des Weiteren umfasst:
einen Widerstands-Teiler (340), der einen ersten Anschlusspunkt hat, der mit dem Ausgangsanschluss der ersten Nachlaufschaltung verbunden ist, einen zweiten Anschlusspunkt hat, der mit dem Ausgangsanschluss der zweiten Nachlaufschaltung verbunden ist, und einen dritten Anschlusspunkt hat, der mit dem zweiten Eingangs-Anschlusspunkt des Schwellenwertdetektors verbunden ist, wobei der Widerstands-Teiler dazu dient, die Schwellenwertspannung VTH am dritten Anschlusspunkt desselben bereitzustellen; und
die Eingriffschaltung (380) mit dem zweiten Eingangs-Anschlusspunkt des Schwellenwefirergleichers (360) verbunden ist.

17. Näherungssensor nach Anspruch 16, wobei die Eingriffsschaltung (380) einen Schaltkreis (382, 384) umfasst, der einen ersten Anschlusspunkt, der mit dem zweiten Eingangs-Anschlusspunkt des Schwellenwertvergleichers (360) verbunden ist, einen zweiten Anschlusspunkt, der mit einer ersten Bezugsspannung verbunden ist, und einen Steuer-Anschlusspunkt hat, der so geschaltet ist, dass er ein Steuersignal empfängt, wobei der Schaltkreis in Reaktion darauf, dass das Steuersignal einen ersten Wert hat, dem zweiten Eingangs-Anschlusspunkt des Schwellenwertvergleichers einen ersten Spannungspegel bereitstellt, und der Schaltkreis in Reaktion darauf, dass das Steuersignal einen zweiten Wert hat, dem zweiten Eingangs-Anschlusspunkt des Schwellenwertvergleichers einen zweiten, anderen Spannungspegel bereitstellt.

18. Näherungsdetektor nach Anspruch 17, wobei der Schaltkreis des Weiteren umfasst:
einen ersten Transistor (382), der einen ersten Anschlusspunkt, der mit dem zweiten Eingangs-Anschlusspunkt des Schwellenwertvergleichers verbunden ist, einen zweiten Anschlusspunkt, der mit einer ersten Bezugsspannung verbunden ist, und einen Steuer-Anschlusspunkt hat;
einen zweiten Transistor (384), der einen ersten Anschlusspunkt, der mit dem zweiten Eingangs-Anschlusspunkt des Schwellenwertvergleichers verbunden ist, einen zweiten Anschlusspunkt, der mit einer zweiten Bezugsspannung verbunden ist, und einen Steuer-Anschlusspunkt hat; und
eine Logikschaltung (306), die ein Anlaufsignal oder ein Rücksetzsignal empfängt und in Reaktion auf das Anlaufsignal oder das Rücksetzsignal den Steuer-Anschlusspunkten des ersten und des zweiten Transistors vorgegebene Steuersignale bereitstellt.

19. Näherungsdetektor nach Anspruch 18, wobei:
der erste Transistor (382) ein Feldeffekttransistor ist, der eine Source-Elektrode, die dem ersten Anschlusspunkt entspricht, eine Drain-Elektrode, die dem zweiten Anschlusspunkt entspricht, und eine Gate-Elektrode hat, die dem dritten Anschlusspunkt entspricht;
der zweite Transistor (384) ein Feldeffekttransistor ist, der eine Source-Elektrode, die dem ersten Anschlusspunkt entspricht, eine Drain-Elektrode, die dem zweiten Anschlusspunkt entspricht, und eine Gate-Elektrode hat, die dem dritten Anschlusspunkt entspricht;
wobei die erste Bezugsspannung einer positiven Bezugsspannung entspricht; und
die zweite Bezugsspannung Erde entspricht.

20. Näherungsdetektor nach Anspruch 19, wobei:
(a) die erste Nachlaufschaltung umfasst:
(1) einen ersten Vergleicher (300), der einen ersten Eingangsanschluss hat, der mit dem Ausgangsanschluss des Magnetfeld-Spannungs-Wandlers verbunden ist, einen zweiten Eingangsanschluss hat und einen Ausgangsanschluss hat;
(2) einen ersten Zähler (314), der einen ersten Eingangsanschluss, der mit dem Ausgangsanschluss des ersten Vergleichers verbunden ist, einen Taktanschluss zum Empfangen eines Taktsignals, einen Anlauf-Anschluss zum Empfangen eines Anlaufsignals und einen Ausgangsanschluss hat; und
(3) einen ersten Digital-Analog-Wandler (318), der einen Eingangsanschluss hat, der mit dem Ausgangsanschluss des zweiten Zählers verbunden ist, und einen Ausgangsanschluss hat, der mit dem zweiten Eingangsanschluss des ersten Vergleichers (300) verbunden ist und dem Ausgangsanschluss der ersten Nachlaufschaltung entspricht; und
(b) die zweite Nachlaufschaltung umfasst:
(1) einen zweiten Vergleicher (304), der einen ersten Eingangsanschluss hat, der mit dem Ausgangsanschluss des Magnetfeld-Spannungs-Wandlers verbunden ist, einen zweiten Eingangsanschluss hat und einen Ausgangsanschluss hat;
(2) einen ersten Zähler (330), der einen ersten Eingangsanschluss, der mit dem Ausgangsanschluss des zweiten Vergleichers verbunden ist, einen Takt-Anschluss zum Empfangen eines Taktsignals, einen Anlauf-Anschluss zum Empfangen eines Anlaufsignals und einen Ausgangsanschluss hat; und
(3) einen zweiten Digital-Analog-Wandler (334), der einen Eingangsanschluss hat, der mit dem Ausgangsanschluss des zweiten Zählers verbunden ist, und einen Ausgangsanschluss hat, der mit dem zweiten Eingangsanschluss des zweiten Vergleichers (304) verbunden ist und dem Ausgangsanschluss der zweiten Nachlaufschaltung entspricht.

21. Verfahren nach Anspruch 10, das des Weitem die folgenden Schritt umfasst:
(d) Zurücksetzen der Spannung PDAC der ersten Nachlaufschaltung auf einen Wert, der niedriger ist als der geringste erwartete positive Wert der Signalspannung V_{sig} in Reaktion auf einen Freigabeimpuls für automatische Verstärkungsregelung; und
(e) Zurücksetzen der Spannung NDAC der zweiten Nachlaufschaltung auf einen Wert, der größer ist als der geringste erwartete negative Wert der Signalspannung V_{sig} in Reaktion auf den Freigabeimpuls zur automatischen Verstärkungsregelung.

## Revendications

1. Un détecteur de proximité destiné à détecter des articles magnétiques comprenant :
a) un transducteur de champ magnétique en tension (10, 252) pour générer en son port de sortie une tension de signal, V_{sig}, qui est proportionnelle à un champ magnétique ; et
b) un détecteur à seuil ayant un port d'entrée couplé au port de sortie dudit transducteur de champ magnétique en tension afin de recevoir la tension de signal V_{sig} et afin de fournir une tension du signal de sortie Vₒᵤₜ ;
**caractérisé en ce que** le détecteur à seuil est un détecteur à seuil proportionnel à la valeur crête à crête et que le détecteur de proximité comprend en outre
c) un circuit de forçage (270, 380) couplé audit détecteur à seuil proportionnel à la valeur crête à crête pour maintenir la valeur de la tension du signal de sortie Vₒᵤₜ à une première valeur prédéterminée au moins jusqu'à ce que soit détectée une variation de tension dans la tension de signal V_{sig} qui est supérieure à une tension prédéterminée.

2. Le détecteur de proximité de la revendication 1 dans lequel :
ledit détecteur à seuil proportionnel à la valeur crête à crête comprend en outre un comparateur de seuil (268a, 268b, 360) ayant une première borne d'entrée couplée au port de sortie dudit transducteur de champ magnétique en tension afin de recevoir la tension de signal, V_{sig}, et ayant une deuxième borne d'entrée couplée afin de recevoir une tension de signal de seuil VTH.

3. Le détecteur de proximité de la revendication 2 dans lequel la tension prédéterminée n'est pas inférieure à une tension d'hystérésis interne dudit comparateur de seuil.

4. Le détecteur de proximité de la revendication 1 dans lequel ledit détecteur à seuil proportionnel à la valeur crête à crête comprend en outre :
un premier circuit de poursuite (260a, 262a, 264a) ayant une entrée couplée à la sortie dudit transducteur de champ magnétique en tension afin de recevoir la tension de signal, V_{sig}, et de générer en sa sortie une tension de signal PDAC qui suit la plus grande valeur crête de la tension de signal V_{sig} ;
un deuxième circuit de poursuite (260b, 262b, 264b) ayant une entrée couplée à la sortie dudit transducteur de champ magnétique en tension afin de recevoir la tension de signal, V_{sig}, et de générer en sa sortie une tension NDAC qui suit la plus petite valeur crête de la tension de signal V_{sig} ; et
un circuit (262a, 262b) pour définir une tension de démarrage initiale de la tension de signal PDAC à une valeur qui est inférieure à une tension de démarrage initiale de la tension de signal NDAC.

5. Le détecteur de proximité de la revendication 2 dans lequel :
(a) ledit détecteur à seuil proportionnel à la valeur crête à crête comprend en outre :
un premier circuit de poursuite (300, 314, 318) ayant une entrée couplée à la sortie dudit transducteur de champ magnétique en tension afin de recevoir la tension de signal, V_{sig}, et de générer à sa sortie une tension de signal PDAC qui suit la plus grande valeur crête de la tension de signal V_{sig} :
un deuxième circuit de poursuite (304, 330, 334) ayant une entrée couplée à la sortie dudit transducteur de champ magnétique en tension afin de recevoir la tension de signal, V_{sig}, et de générer en sa sortie une tension NDAC qui suit la plus petite valeur crête de la tension de signal V_{sig} ; et
un pont diviseur à résistances (340) ayant une première borne couplée au port de sortie dudit premier circuit de poursuite, ayant une deuxième borne couplée au port de sortie dudit deuxième circuit de poursuite et ayant une troisième borne couplée à la deuxième borne d'entrée dudit détecteur à seuil, ledit pont diviseur à résistances étant destiné à fournir la tension de signal de seuil VTH à sa troisième borne ; et
(b) ledit circuit de forçage (380) est couplé à la deuxième borne d'entrée dudit comparateur de seuil.

6. Le détecteur de proximité de la revendication 5 dans lequel ledit circuit de forçage comprend un circuit de commutation (382, 384) ayant une première borne couplée à la deuxième borne d'entrée dudit comparateur de seuil, une deuxième borne couplée à une première tension de référence et une borne de commande couplée pour recevoir un signal de commande et, en réponse au signal de commande ayant une première valeur, ledit circuit de commutation fournit un premier niveau de tension à la deuxième borne d'entrée dudit comparateur de seuil et, en réponse au signal de commande ayant une deuxième valeur, ledit circuit de commutation fournit un deuxième niveau de tension différent à la deuxième borne d'entrée dudit comparateur de seuil.

7. Le détecteur de proximité de la revendication 6 dans lequel ledit circuit de commutation comprend en outre :
un premier transistor (382) ayant une première borne couplée à la deuxième borne d'entrée dudit comparateur de seuil, une deuxième borne couplée à une première tension de référence et une borne de commande ;
un deuxième transistor (384) ayant une première borne couplée à la deuxième borne d'entrée dudit comparateur de seuil, une deuxième borne couplée à une deuxième tension de référence et une borne de commande ; et
un circuit logique (306) destiné à recevoir un signal de démarrage et destiné à fournir des signaux de commande prédéterminés aux bornes de commande desdits premier et deuxième transistors en réponse au signal de démarrage ayant une valeur prédéterminée.

8. Le détecteur de proximité de la revendication 7 dans lequel :
ledit premier transistor (382) est un transistor à effet de champ ayant des électrodes de source, drain et grille et dans lequel la première borne correspond à l'électrode de drain, la deuxième borne correspond à l'électrode de source et la borne de commande correspond à l'électrode de grille ;
ledit deuxième transistor (384) est un transistor à effet de champ ayant des électrodes de source, drain et grille dans lequel la première borne correspond à l'électrode de drain, la deuxième borne correspond à l'électrode de source et la borne de commande correspond à l'électrode de grille ;
ladite première tension de référence correspond à une tension de référence positive ; et
ladite deuxième tension de référence correspond à la masse.

9. Le détecteur de proximité de la revendication 8 dans lequel :
(a) ledit premier circuit de poursuite comprend :
(1) un premier comparateur (300) ayant un premier port d'entrée couplé au port de sortie dudit transducteur de champ magnétique en tension, ayant un deuxième port d'entrée et ayant un port de sortie ;
(2) un deuxième compteur (314) ayant un premier port d'entrée couplé au port de sortie dudit premier comparateur, un port d'horloge destiné à recevoir un signal d'horloge, un port de démarrage destiné à recevoir un signal de démarrage et un port de sortie ; et
(3) un premier convertisseur numérique analogique (318) ayant un port d'entrée couplé au port de sortie dudit deuxième compteur et ayant un port de sortie couplé au deuxième port d'entrée dudit premier comparateur (300) et correspondant au port de sortie dudit premier circuit de poursuite ; et
(b) ledit deuxième circuit de poursuite comprend :
(1) un deuxième comparateur (304) ayant un premier port d'entrée couplé au port de sortie dudit transducteur de champ magnétique en tension, ayant un deuxième port d'entrée et ayant un port de sortie ;
(2) un premier compteur (330) ayant un premier port d'entrée couplé au port de sortie dudit deuxième comparateur, un port d'horloge destiné à recevoir un signal d'horloge, un port de démarrage destiné à recevoir un signal de démarrage et un port de sortie ; et
(3) un deuxième convertisseur numérique analogique (334) ayant un port d'entrée couplé au port de sortie dudit premier compteur et ayant un port de sortie couplé au deuxième port d'entrée dudit deuxième comparateur (304) et correspondant au port de sortie dudit deuxième circuit de poursuite.

10. Un procédé associé à un détecteur de proximité comprenant un transducteur de champ magnétique en tension (10, 252) qui fournit une tension de signal, V_{sig}, à un détecteur à seuil qui comprend un comparateur de seuil (268a, 268b, 360) et qui génère une tension du signal de sortie Vₒᵤₜ, **caractérisé en ce que** le détecteur à seuil est un détecteur à seuil proportionnel à la valeur crête à crête qui comprend des premier et deuxième circuits de poursuite, et le procédé comprend les étapes consistant à :
(a) définir une valeur de sortie du premier circuit de poursuite à une valeur qui est inférieure à la plus petite valeur positive attendue de la tension de signal . V_{sig} dans lequel le premier circuit de poursuite reçoit la tension de signal V_{sig}, et génère en son port de sortie une tension PDAC qui suit la plus grande valeur crête de la tension de signal V_{sig} ;
(b) définir une valeur de sortie du deuxième circuit de poursuite à une valeur qui est supérieure à la plus petite valeur négative attendue de la tension de signal V_{sig} dans lequel le deuxième circuit de poursuite reçoit la tension de signal V_{sig}, et génère en son port de sortie une tension de signal NDAC qui suit la plus petite valeur crête de la tension de signal V_{sig} ; et
(c) maintenir la tension du signal de sortie Vₒᵤₜ à une première valeur prédéterminée en appliquant une tension de référence à une borne d'entrée dudit comparateur de seuil, dans lequel la valeur de la tension du signal de sortie Vₒᵤₜ est maintenue au moins jusqu'à ce que le détecteur à seuil proportionnel à la valeur crête à crête détecte une variation dans la tension de signal V_{sig} qui est supérieure à une tension prédéterminée.

11. Le procédé de la revendication 10 comprenant en outre les étapes consistant à :
(d) détecter un champ magnétique ambiant et à générer la tension, V_{sig}, qui est proportionnelle au champ magnétique ; et
(e) en réponse à la détection d'une variation de tension dans la tension de signal V_{sig} qui est supérieure à la tension prédéterminée, supprimer la tension de référence de la borne d'entrée dudit comparateur de seuil.

12. Le procédé de la revendication 11 dans lequel l'étape consistant à maintenir la tension du signal de sortie Vₒᵤₜ à une première valeur prédéterminée en appliquant une tension de référence à une borne d'entrée dudit comparateur de seuil (360) comprend les étapes consistant à :
polariser un premier transistor (382) couplé entre une tension de référence et la borne d'entrée dudit comparateur de seuil en un premier état parmi un état de conduction et un état de non conduction.

13. Le procédé de la revendication 12 dans lequel l'étape consistant à supprimer la tension de référence de la borne d'entrée dudit comparateur de seuil comprend l'étape consistant à :
polariser la premier transistor (382) dans un deuxième état parmi les états de conduction et de non conduction.

14. Le détecteur de proximité de la revendication 1 comprenant en outre :
un circuit de commande de gain automatique (12) ayant un port d'entrée couplé au port de sortie dudit transducteur de champ magnétique en tension (10) et ayant un port de sortie couplé au port d'entrée du détecteur à seuil proportionnel à la valeur crête à crête, dans lequel ledit circuit de forçage est couplé en outre audit circuit de commande de gain automatique destiné à maintenir la valeur de la tension du signal de sortie Vₒᵤₜ à une première valeur prédéterminée afin d'empêcher ledit détecteur à seuil proportionnel à la valeur crête à crête de commuter avant une excursion positive ou négative de la tension de signal V_{sig} qui atteint une tension de seuil prédéterminée lorsque ledit circuit de commande de gain automatique commande l'amplitude de la tension de signal V_{sig}.

15. Le détecteur de proximité de la revendication 14 dans lequel :
ledit détecteur à seuil proportionnel à la valeur crête à crête comprend en outre :
un premier circuit de poursuite (300, 314, 318) ayant un port d'entrée couplé au port de sortie dudit transducteur de champ magnétique en tension afin de recevoir la tension de signal, V_{sig}, et afin de générer en son port de sortie une tension de signal PDAC qui suit la plus grande valeur crête de la tension de signal V_{sig} ;
un deuxième circuit de poursuite (304, 330, 334) ayant un port d'entrée couplé au port de sortie dudit transducteur de champ magnétique en tension afin de recevoir la tension de signal, V_{sig}, et afin de générer en son port de sortie une tension NDAC qui suit la plus petite valeur crête de la tension de signal V_{sig} ; et
un comparateur de seuil (360) ayant une première borne d'entrée couplée au port de sortie dudit circuit de commande de gain automatique (12) afin de recevoir la tension de signal, V_{sig}, et ayant une deuxième borne d'entrée couplée pour recevoir une tension de seuil VTH ;
ledit circuit de commande de gain automatique comprend :
un circuit logique (292) couplé auxdits premier et deuxième circuits de poursuite, ledit circuit logique afin de générer un signal de réinitialisation afin de réinitialiser la tension PDAC dudit premier circuit de poursuite à une valeur qui est inférieure à la plus petite valeur positive attendue de la tension de signal V_{sig} et de réinitialiser la tension NDAC dudit deuxième circuit de poursuite à une valeur qui est supérieure à la plus petite valeur négative attendue de la tension de signal V_{sig} ; et
ledit circuit de forçage (380) maintient la valeur de la tension du signal de sortie Vₒᵤₜ à une première valeur prédéterminée au moins jusqu'à ce que le détecteur à seuil proportionnel à la valeur crête à crête détecte une variation de tension dans la tension de signal V_{sig} qui est supérieure à une tension prédéterminée.

16. Le détecteur de proximité de la revendication 15 dans lequel :
ledit détecteur à seuil proportionnel à la valeur crête à crête comprend en outre :
un pont diviseur à résistances (340) ayant une première borne couplée au port de sortie dudit premier circuit de poursuite, ayant une deuxième borne couplée au port de sortie dudit deuxième circuit de poursuite et ayant une troisième borne couplée à la deuxième borne d'entrée dudit détecteur à seuil, ledit pont diviseur à résistances étant destiné à fournir la tension de seuil VTH sur sa troisième borne ; et
ledit circuit de forçage (380) est couplé à la deuxième borne d'entrée dudit comparateur de seuil (360).

17. Le détecteur de proximité de la revendication 16 dans lequel ledit circuit de forçage (380) comprend un circuit de commutation (382, 384) ayant une première borne couplée à la deuxième borne d'entrée dudit comparateur de seuil (360), une deuxième borne couplée à une première tension de référence et une borne de commande couplée pour recevoir un signal de commande dans lequel, en réponse au signal de commande ayant une première valeur, ledit circuit de commutation fournit un premier niveau de tension à la deuxième borne d'entrée dudit comparateur de seuil et, en réponse au signal de commande ayant une deuxième valeur, ledit circuit de commutation fournit un deuxième niveau de tension différent à la deuxième borne d'entrée dudit comparateur de seuil.

18. Le détecteur de proximité de la revendication 17 dans lequel ledit circuit de commutation comprend en outre :
un premier transistor (382) ayant une première borne couplée à la deuxième borne d'entrée dudit comparateur de seuil, une deuxième borne couplée à une première tension de référence et une borne de commande ;
un deuxième transistor (384) ayant une première borne couplée à la deuxième borne d'entrée dudit comparateur de seuil, une deuxième borne couplée à une deuxième tension de référence et une borne de commande ; et
un circuit logique (306) destiné à recevoir un signal de démarrage et un signal de réinitialisation, et destiné à fournir des signaux de commande prédéterminés aux bornes de commande desdits premier et deuxième transistors en réponse au signal de démarrage et au signal de réinitialisation.

19. Le détecteur de proximité de la revendication 18 dans lequel :
ledit premier transistor (382) est un transistor à effet de champ ayant une électrode de source correspondant à la première borne, une électrode de drain correspondant à la deuxième borne et une électrode de grille correspondant à la troisième borne ;
ledit deuxième transistor (384) est un transistor à effet de champ ayant une électrode de source correspondant à la première borne, une électrode de drain correspondant à la deuxième borne et une électrode de grille correspondant à la troisième borne ;
ladite première tension de référence correspond à une tension de référence positive ; et
ladite deuxième tension de référence correspond à la masse.

20. Le détecteur de proximité de la revendication 19 dans lequel :
(a) ledit premier circuit de poursuite comprend :
(1) un premier comparateur (300) ayant un premier port d'entrée couplé au port de sortie dudit transducteur de champ magnétique en tension, ayant un deuxième port d'entrée et ayant un port de sortie ;
(2) un premier compteur (314) ayant un premier port d'entrée couplé au port de sortie dudit premier comparateur, un port d'horloge destiné à recevoir un signal d'horloge, un port de démarrage destiné à recevoir un signal de démarrage et un port de sortie ; et
(3) un premier convertisseur numérique analogique (318) ayant un port d'entrée couplé au port de sortie dudit premier compteur et ayant un port de sortie couplé au deuxième port d'entrée dudit premier comparateur (300) et correspondant au port de sortie dudit premier circuit de poursuite ; et
(b) ledit deuxième circuit de poursuite comprend :
(1) un deuxième comparateur (304) ayant un premier port d'entrée couplé au port de sortie dudit transducteur de champ magnétique en tension, ayant un deuxième port d'entrée et ayant un port de sortie ;
(2) un deuxième compteur (330) ayant un premier port d'entrée couplé au port de sortie dudit deuxième comparateur, un port d'horloge destiné à recevoir un signal d'horloge, un port de démarrage destiné à recevoir un signal de démarrage et un port de sortie ; et
(3) un deuxième convertisseur numérique analogique (334) ayant un port d'entrée couplé au port de sortie dudit deuxième compteur et ayant un port de sortie couplé au deuxième port d'entrée dudit deuxième comparateur (304) et correspondant au port de sortie dudit deuxième circuit de poursuite.

21. Le procédé de la revendication 10 comprenant en outre les étapes consistant à :
(d) réinitialiser la tension PDAC dudit premier circuit de poursuite à une valeur qui est inférieure à la plus petite valeur positive attendue de la tension de signal V_{sig} en réponse à une impulsion d'activation de commande de gain automatique ; et
(e) réinitialiser la tension NDAC dudit deuxième circuit de poursuite à une valeur qui est supérieure à la plus petite valeur négative attendue de la tension de signal V_{sig} en réponse à l'impulsion d'activation de commande de gain automatique.
